# EUROPEAN PATENT APPLICATION

(11) **EP 4 502 078 A1**
(43) Date of publication of application: **05.02.2025**
(21) Application number: 23780504.9
(22) Date of filing: 28.03.2023
(51) Int. Cl.: C08L 101/00, C08K 3/22, H01L 33/56

(54) **DISPERSION LIQUID, COMPOSITION, SEALING MEMBER, LIGHT EMITTING DEVICE, LIGHTING TOOL, DISPLAY DEVICE, AND METHOD FOR PRODUCING DISPERSION LIQUID**

(30) Priority: 31.03.2022 JP 2022058694
(71) Applicant: Sumitomo Osaka Cement Co., Ltd., Tokyo, 105-8641 (JP)
(72) Inventor: TAKEDA, Ryo, Tokyo 105-8641 (JP); ITO, Tomomi, Tokyo 105-8641 (JP); HARADA, Kenji, Tokyo 105-8641 (JP)
(74) Representative: Becker, Eberhard
(86) International application number: PCT/JP2023/012468
(87) International publication number: WO 2023/190495

(57) **Abstract**

This dispersion liquid comprises metal oxide particles surface-modified by a surface-modifying material, and a hydrophobic solvent, wherein: the metal oxide particles have a refraction index of 1.70 to 2.00; the surface-modifying material comprises a silane compound and a silicone compound; the silane compound comprises a methyl group-containing silane compound; when the dispersion liquid and a methyl phenyl silicone are mixed such that the ratio of the combined mass of the metal oxide particles and the surface-modifying material to the mass of the methyl phenyl silicone is 7:93 and this mixture is cured to form an article having a thickness of 1 mm, the portion of the 450 nm wavelength scattered by the cured material is 17% to 380; and the value obtained by dividing the portion of 450 nm wavelength scattered by the cured material by the portion of 600 nm wavelength scattered by the cured material is 1.25 or more.

## Description

### Technical Field

The present invention relates to a dispersion liquid for sealing a light emitting element, a composition, a sealing member, a light emitting device, an illumination tool, a display device, and a method for producing a dispersion liquid.

This application claims priority based on Japanese Patent Application No. 2022-058694 filed on March 31, 2022, the content of which is incorporated herein by reference.

### Background Art

As a light source having advantages such as a small size, a long service life, a low-voltage driving, and the like, light emitting diodes (LED) are being broadly used. An LED chip in an LED package is generally sealed with a sealing material including a resin in order to prevent a contact with a deterioration factor present in the external environment such as oxygen or moisture. Therefore, light emitted from the LED chip passes through the sealing material and is emitted outwards. Therefore, it is important to efficiently extract the light emitted from the LED chip to the outside of the LED package after wavelength conversion by the particles of a fluorescent body in order to increase the luminous flux emitted from the LED package.

For extended service lives of LEDs, there has been an increasing demand for a highly heat-resistant methyl-based silicone resin as a sealing resin that is used in sealing materials. The methyl-based silicone resin has a large content of methyl groups and a high degree of hydrophobicity, as compared with a phenyl silicone resin and the like that have been generally used in the related art. Therefore, as described in Patent Literature No. 1, there has been a problem that even with metal oxide particles having a hydrophobized surface, in a case where the metal oxide particles are mixed with a methyl-based silicone resin, the metal oxide particles are agglomerated with each other, and thus, a transparent composition cannot be obtained. Such a problem is more significant as the content of the metal oxide particles in a sealing material increases.

In Patent Literature No. 2, a dispersion liquid for sealing a light emitting element in which agglomeration of metal oxide particles is suppressed even in a methyl-based silicone resin having high heat resistance by performing surface modification with a high-concentration surface-modifying material; and the like are proposed.

### Citation List

### Patent Literature

[Patent Literature No. 1] International Publication No. 2016/142992
[Patent Literature No. 2] International Publication No. 2020/203462

### Summary of Invention

### Technical Problem

In a light emitting device using a methyl-based silicone resin, a further improvement in the brightness of light is required.

The present invention has been made in view of the circumstances, and an object of the present invention is to provide a dispersion liquid capable of improving the brightness of a light emitting device even in a case where a methyl-based silicone resin is used as a sealing material, a composition, a sealing member formed using the composition, a light emitting device having the sealing member, an illumination tool and a display device, each provided with the light emitting device, and a method for producing a dispersion liquid.

### Solution to Problem

In order to accomplish the object, a first aspect of the present invention provides a dispersion liquid including metal oxide particles surface-modified with a surface-modifying material, and a hydrophobic solvent, in which the metal oxide particles have a refractive index of 1.70 or higher and 2.00 or lower, the surface-modifying material includes a silane compound and a silicone compound, the silane compound includes a methyl group-containing silane compound, and in a case where the dispersion liquid and methyl phenyl silicone are mixed such that a ratio of a total mass of the metal oxide particles and the surface-modifying material to a mass of methyl phenyl silicone is 7:93, thereby obtaining a cured product having a thickness of 1 mm, a scattering fraction at a wavelength of 450 nm of the cured product is 170 or more and 38% or less, and a value obtained by dividing the scattering fraction at a wavelength of 450 nm of the cured product by a scattering fraction at a wavelength of 600 nm of the cured product is 1.25 or higher.

In order to accomplish the object, a second aspect of the present invention provides a composition which is a mixture of the dispersion liquid and a resin component.

In order to accomplish the object, a third aspect of the present invention provides a sealing member which is a cured product of the composition.

In order to accomplish the object, a fourth aspect of the present invention provides a light emitting device provided with the sealing member and a light emitting element sealed by the sealing member.

In order to accomplish the object, a fifth aspect of the present invention provides an illumination tool provided with the light emitting device.

In order to accomplish the object, a sixth aspect of the present invention provides a display device provided with the light emitting device.

In order to accomplish the object, a seventh aspect of the present invention provides a method for producing a dispersion liquid, the method including a step B of mixing a silane compound and metal oxide particles to obtain a liquid mixture, a step C of dispersing the metal oxide particles in the liquid mixture to obtain a first dispersion liquid in which the metal oxide particles are dispersed, a step D of adding a hydrophobic solvent to the first dispersion liquid to obtain a second dispersion liquid, and a step E of adding a silicone compound to the second dispersion liquid to obtain a third dispersion liquid, in which the metal oxide particles have a refractive index of 1.70 or higher and 2.00 or lower, the silane compound includes a methyl group-containing silane compound and a silane compound containing a hydrocarbon group having 2 to 5 carbon atoms, in the step B, a content of the metal oxide particles in the liquid mixture is 10% by mass or more and 49% by mass or less, and a total content of the silane compound and the metal oxide particles in the liquid mixture is 65% by mass or more and 98% by mass or less, and the step D is any of a step d1 of heating the first dispersion liquid and then adding the hydrophobic solvent to the first dispersion liquid at a rate at which the metal oxide particles are not agglomerated, a step d2 of adding the hydrophobic solvent to the first dispersion liquid at a rate at which the metal oxide particles are not agglomerated, while heating the first dispersion liquid, or a step d3 of adding the hydrophobic solvent to the first dispersion liquid at a rate at which the metal oxide particles are not agglomerated, and then heating the first dispersion liquid.

### Advantageous Effects of Invention

According to the present invention, it is possible to provide a dispersion liquid capable of improving the brightness of a light emitting device, a composition, a sealing member formed using the composition, a light emitting device having the sealing member, an illumination tool and a display device, each provided with the light emitting device, and a method for producing a dispersion liquid.

### Brief Description of Drawings

FIG. 1 is a schematic view showing an example of a light emitting device according to an embodiment of the present invention.
FIG. 2 is a schematic view showing another example of the light emitting device according to the embodiment of the present invention.
FIG. 3 is a schematic view showing still another example of the light emitting device according to the embodiment of the present invention.
FIG. 4 is a schematic view showing yet still another example of the light emitting device according to the embodiment of the present invention.
FIG. 5 is a field emission transmission electron microscope image of a cured product of Example 1.
FIG. 6 is a field emission transmission electron microscope image of the cured product of Example 1.
FIG. 7 is a field emission transmission electron microscope image of a cured product of Comparative Example 1.
FIG. 8 is a field emission transmission electron microscope image of the cured product of Comparative Example 1.

### Description of Embodiments

Examples of preferred embodiments of the dispersion liquid, the composition, the sealing member, the light emitting device, the illumination tool, the display device, and the method for producing a dispersion liquid of the present invention will be described.

Furthermore, the present embodiments will be described in detail for better understanding the gist of the invention, and the present invention is not limited unless otherwise specified. The amount, the number, the type, the ratio, the configuration, the position, the order, the ratio, and the like can be omitted, added, substituted, or changed within a range that does not depart from the gist of the present invention.

First, prior to the detailed description of the present invention, an idea by the present inventors, which leads to the present invention, will be described.

In the related art, the present inventors have considered that it is important to configure a sealing member to contain metal oxide particles having a higher refractive index in order to improve the brightness of a light emitting device including an LED chip. That is, the present inventors have considered that the metal oxide particles having a high refractive index enable light emitted from a light emitting element to be more scattered, which can contribute to an increase in the refractive index of the sealing member. Therefore, the present inventors have considered that it is important to use metal oxide particles having a higher refractive index in order to improve the brightness of an LED light emitting device.

However, surprisingly, in a case where aluminum oxide particles having a refractive index of about 1.8 were used, the brightness of an LED package was sometimes improved, as compared with a case where zirconium oxide particles having a refractive index of about 2.1 were used.

The present inventors have examined a mechanism by which the present phenomenon occurs, and as a result, have obtained the following findings.

In a case where the number of large agglomerated particle diameters between the metal oxide particles in the sealing member is large even with the metal oxide particles having a refractive index of 2.01 or higher, the brightness may be lower than that of an LED light emitting device using metal oxide particles having a refractive index of 1.70 or higher and 2.00 or lower.

On the other hand, in a case where the number of large agglomerated particle diameters between the metal oxide particles in the sealing member is small, even with a use of metal oxide particles having a refractive index of 1.70 or higher and 2.00 or lower, the brightness may be higher than that of an LED light emitting device using metal oxide particles having a refractive index of 2.01 or higher.

The following is presumed from this phenomenon.

In an LED light emitting device, blue light emitted from a light emitting element should be more scattered to be brought into contact with particles of a fluorescent body. However, in a case where the light is excessively scattered after being wavelength-converted to the long-wavelength side by the contact with the particles of a fluorescent body, the amount of light emitted from the LED light emitting device is reduced, which thus causes an insufficient brightness of the LED light emitting device.

As a result of trial and error based on this presumption, it was found that, in a state of a cured product not including the particles of a fluorescent body, light at a wavelength of 450 nm is easily scattered, and light at a wavelength of 600 nm, which is located on a longer wavelength side, is difficult to be scattered, in a dispersion liquid capable of improving the brightness of the LED light emitting device. That is, it was found that a balance of scattering of light at a wavelength of 450 nm and light at a wavelength of 600 nm is important. Furthermore, the wavelength of the blue to blue-violet light is approximately 430 to 500 nm.

In the sealing member, it is necessary that the metal oxide particles in the sealing member have a certain size or more in order to scatter the blue light emitted from the LED chip. However, in a case where the refractive index of the metal oxide particles is excessively large, light wavelength-converted by the particles of a fluorescent body is also easily scattered. As a result, the metal oxide particles having a high refractive index have a high scattering efficiency of the blue light emitted from the LED chip, but tend to inhibit the transmission of the light after being wavelength-converted by the particles of a fluorescent body. Consequently, it is difficult to efficiently extract the light emitted from the LED chip to the outside of the LED light emitting device.

On the other hand, in a case where the metal oxide particles having a refractive index of 1.70 or higher and 2.00 or lower are used, a scattering effect of blue light is inferior to that of the metal oxide particles having a refractive index of 2.01 or higher, but it is less likely to inhibit the transmission of light after being wavelength-converted. As a result, the light emitted from the LED chip can be efficiently extracted to the outside of the LED light emitting device.

Based on the above idea, the present inventors have completed the dispersion liquid of the present invention, which makes it possible to obtain desired optical characteristics at a wavelength of 450 nm and a wavelength of 600 nm by using metal oxide particles having a refractive index of 1.70 or higher and 2.00 or lower.

### (Dispersion Liquid)

The dispersion liquid of the present embodiment includes metal oxide particles surface-modified with a surface-modifying material, and a hydrophobic solvent, in which the metal oxide particles have a refractive index of 1.70 or higher and 2.00 or lower, the surface-modifying material includes a silane compound and a silicone compound, the silane compound includes a methyl group-containing silane compound, and in a case where the dispersion liquid and methyl phenyl silicone are mixed such that a ratio of a total mass of the metal oxide particles and the surface-modifying material to a mass of methyl phenyl silicone is 7:93, thereby obtaining a cured product having a thickness of 1 mm, a scattering fraction at a wavelength of 450 nm of the cured product is 170 or more and 38% or less, and a value obtained by dividing the scattering fraction at a wavelength of 450 nm of the cured product by a scattering fraction at a wavelength of 600 nm of the cured product is 1.25 or higher.

The dispersion liquid of the present embodiment is for sealing a light emitting element.

The silane compound may include a silane compound containing a hydrocarbon group having 2 to 5 carbon atoms, in addition to the methyl group-containing silane compound.

In a case where the silane compound includes the silane compound containing a hydrocarbon group having 2 to 5 carbon atoms, a mass ratio of the methyl group-containing silane compound to the silane compound containing a hydrocarbon group having 2 to 5 carbon atoms is preferably in a range of 99:1 to 35:65.

In the present embodiment, the "scattering fraction" means a value obtained by subtracting a linear transmittance value (%) from an integrated transmittance value (%). The integrated transmittance means a transmittance measured with a spectrophotometer using an integrating sphere. The linear transmittance means a transmittance measured with a spectrophotometer using an integrating sphere.

In a case where the dispersion liquid and methyl phenyl silicone are mixed such that the ratio of a total mass of the metal oxide particles and the surface-modifying material to a mass of methyl phenyl silicone is 7:93, thereby obtaining a cured product having a thickness of 1 mm, a scattering fraction at a wavelength of 450 nm of the cured product is 170 or more and 38% or less, and more preferably 200 or more and 35% or less. The scattering fraction may be, for example, 210 or more and 33% or less, or 220 or more and 300 or less. In a case where the scattering fraction at a wavelength of 450 nm of the cured product is 17% or more, light emitted from a light emitting element can be sufficiently scattered. Furthermore, in a case where the scattering fraction at a wavelength of 450 nm of the cured product is 380 or less, a sealing member having a good balance of scattering of light at a wavelength of 450 nm and scattering of light at a wavelength of 600 nm can be obtained.

A value obtained by dividing a scattering fraction at a wavelength of 450 nm of the cured product by a scattering fraction at a wavelength of 600 nm of the cured product is 1.25 or higher, preferably 1.27 or higher, and more preferably 1.29 or higher. An upper limit value of the value obtained by dividing the scattering fraction at a wavelength of 450 nm of the cured product by the scattering fraction at a wavelength of 600 nm of the cured product is not particularly limited, and may be 2.00 or less, may be 1.80 or less, or may be 1.60 or less. The value may be 1.26 or higher and 1.90 or lower, or 1.28 or higher and 1.50 or lower.

By setting the value obtained by dividing the scattering fraction at a wavelength of 450 nm of the cured product by the scattering fraction at a wavelength of 600 nm of the cured product to 1.25 or higher, light on the low wavelength side is scattered while the light on the high wavelength side is suppressed from scattering, which can improve the brightness of light of a light emitting device.

The scattering fraction at a wavelength of 600 nm of the cured product is preferably 130 or more and 29% or less, and preferably 140 or more and 28% or less. In a case where the scattering fraction at a wavelength of 600 nmm of the cured product is within the ranges, it is easy to control the value obtained by dividing the scattering fraction at a wavelength of 450 nm of the cured product by the scattering fraction at a wavelength of 600 nm of the cured product by 1.25 or higher.

In the present embodiment, the expression "a ratio of a total mass of the metal oxide particles and the surface-modifying material to a mass of methyl phenyl silicone is 7:93, thereby obtaining a cured product having a thickness of 1 mm" means that a cured product having a thickness of 1 mm is formed by using only the metal oxide particles, the surface-modifying material, methyl phenyl silicone, and a curing agent necessary for curing the methyl phenyl silicone. That is, the expression means that materials generally included in the sealing member, such as particles of a fluorescent body and the like, are not included in the cured product.

Since the particles of a fluorescent body and the like affect the optical characteristics of the cured product, a measurement of the scattering characteristics of the metal oxide particles is hindered. Therefore, the cured product is formed only from the metal oxide particles, the surface-modifying material, and a material necessary for curing methyl phenyl silicone, other than methyl phenyl silicone. A material which does not inhibit the scattering characteristics of the metal oxide particles may be included in the cured product.

A reason why methyl phenyl silicone is used in a case of forming the cured product having a thickness of 1 mm is that, as compared with a phenyl-based silicone in the related art, particles excessively agglomerated in the cured product are easily generated, and it is thus difficult to obtain desired scattering characteristics. With a cured product obtained by using methyl phenyl silicone having excellent heat resistance, for which a dispersion liquid capable of providing desired scattering characteristics is used, the brightness of the light emitting device can be improved regardless of the type of the resin component.

The dispersion liquid of the present embodiment includes metal oxide particles, in which the metal oxide particles having a refractive index of 1.70 or higher and 2.00 or lower are densely surface-modified with a surface-modifying material including a methyl group-containing silane compound and a silicone compound by a production method which will be described later (which may hereinafter be simply referred to as "surface-modified metal oxide particles"). The dispersion liquid of the present embodiment can disperse the surface-modified metal oxide particles of the present embodiment while controlling the size to an extent that scatters light at a wavelength of 450 nm or higher in the sealing member while making it possible to suppress the scattering of light at a wavelength of 600 nm. Therefore, in a case of using the dispersion liquid of the present embodiment, the brightness of the light emitting device can be improved.

In the composition of the present embodiment, it is considered that since the surface-modified metal oxide particles obtained by the production method which will be described later are used, the agglomeration state of the surface-modified metal oxide particles in the sealing member can be controlled to a desired size. That is, by directly dispersing the metal oxide particles in the methyl group-containing silane compound, the metal oxide particles could be uniformly mixed even in a case where the resin component is a methyl-based silicone resin. In the surface-modified metal oxide particles in the present embodiment, it is presumed that more silane compounds are attached to the metal oxide particles and a dense coating is formed, as compared with surface-modified metal oxide particles in the related art.

Furthermore, it is not clear that the scattering fraction at a wavelength of 450 nm of the cured product and the scattering fraction at a wavelength of 600 nm of the cured product can be set to desired values due to a certain state of the surfaces of the metal oxide particles. Therefore, it is difficult to directly specify the characteristics of the dispersion liquid of the present embodiment from the state of the surfaces of the metal oxide particles modified with the methyl group-containing silane compound and the silicone compound.

Furthermore, it is not easy to simply specify in words the surface state that enables the surface-modified metal oxide particles according to the present embodiment to be dispersed in the cured product such that desired scattering characteristics are obtained. The dispersibility of the surface-modified metal oxide particles in the sealing member such that desired scattering characteristics are obtained is presumed to be expressed by a complicated interrelationship of a large number of factors such as a structure of the surface-modifying material, a degree of polymerization of the surface-modifying material, characteristics of the metal oxide particles, characteristics of the sealing resin, and the like.

However, according to the present invention, it is possible to easily provide a sealing member capable of improving the brightness of the light emitting device by adjusting a dispersion state of the surface-modified metal oxide particles by evaluating the scattering fraction at a wavelength of 450 nm of the cured product and the scattering fraction at a wavelength of 600 nm of the cured product.

In the present invention, the scattering characteristics at a wavelength of 450 nm of the cured product and the scattering characteristics at a wavelength of 600 nm of the cured product are controlled in consideration of an influence of the blue LED. However, in a case where the color emitted from the light emitting element is a color other than blue, the dispersion state of the surface-modified metal oxide particles in the dispersion liquid only needs to be controlled such that the wavelength of the emitted color and the scattering characteristics at a wavelength of 600 nm are within a desired range.

In a case where it is difficult to control the scattering characteristics at a wavelength of 450 nm of the cured product and the scattering characteristics at a wavelength of 600 nm of the cured product only by the dispersion state of the surface-modified metal oxide particles in the dispersion liquid, the refractive index of the metal oxide particles only needs to be adjusted to control the scattering characteristics at a wavelength of 450 nm of the cured product and the scattering characteristics at a wavelength of 600 nm of the cured product within desired ranges.

In a case where metal oxide particles having a refractive index of 1.70 or higher and 2.00 or lower are used, the light scattering effect is smaller than that of metal oxide particles having a refractive index of 2.01 or higher even with a slight increase in the particle diameter of the surface-modified metal oxide particles in the sealing member. Therefore, it is possible to obtain a sealing member having an excellent scattering balance between light at a wavelength of 450 nm and light at a wavelength of 600 nm by dispersing the metal oxide particles having a refractive index of 1.70 or higher and 2.00 or lower in the sealing member to an extent that the metal oxide particles are not excessively agglomerated. Furthermore, a light emitting device provided with the sealing member manufactured using such a dispersion liquid has an improved brightness of light.

It is troublesome to adjust the metal oxide particles, the type of the surface-modifying material, the contents of the metal oxide particles and the surface-modifying material, and the dispersion conditions every time the type of the resin component for sealing the light emitting element is changed. However, according to the present invention, it has been demonstrated that, in a case where the dispersion state of the surface-modified metal oxide particles in the dispersion liquid is controlled such that the scattering characteristics at a wavelength of 450 nm of the cured product and the scattering characteristics at a wavelength of 600 nm of the cured product are within desired ranges, the brightness of the LED light emitting device can be improved.

Hereinafter, each component included in the present embodiment will be described.

### (Metal Oxide Particles)

The metal oxide particles scatter light emitted from a light emitting element in a sealing member which will be described below. In addition, the metal oxide particles improve the refractive index of the sealing member, depending on the type of the metal oxide particles. This makes the metal oxide particles contribute to an improvement in the brightness of light in the light emitting device.

The metal oxide particles before the surface modification have a refractive index of 1.70 or higher and 2.00 or lower, and more preferably have a refractive index of 1.80 or higher and 1.98 or lower. The metal oxide particles after the surface modification may also have the same refractive index. The refractive index may be 1.73 or higher and 1.95 or lower, or 1.75 or higher and 1.93 or lower. As the metal oxide particles in the present embodiment, for example, aluminum oxide particles, yttrium oxide particles, or hafnium oxide particles can be used. From the viewpoint that the dispersion state is easily controlled during the manufacture of a dispersion liquid, aluminum oxide particles are preferable.

The metal oxide particles may be dispersed as primary particles in the dispersion liquid or may be dispersed as secondary particles formed by agglomeration of the primary particles. Typically, the metal oxide particles are dispersed as the secondary particles.

In the dispersion liquid of the present embodiment, an average dispersed particle diameter of the metal oxide particles is not particularly limited as long as it is a value at which the dispersed particle diameters (agglomerated particle diameters) in the sealing member are 60 nm or higher and 1,000 nm or lower. The average dispersed particle diameter of the metal oxide particles may be, for example, 30 nm or higher and 1,000 nm or lower, may be 50 nm or higher and 800 nm or lower, or may be 60 nm or higher and 700 nm or lower.

Since the agglomeration state of the metal oxide particles in the cured product varies depending on a combination of the metal oxide particles, the surface-modifying material, the resin component, and the particles of a fluorescent body, and the curing conditions of the composition, the average dispersed particle diameter of the metal oxide particles in the dispersion liquid only needs to be adjusted while confirming the scattering characteristics at a wavelength of 450 nm and the scattering characteristics at a wavelength of 600 nm in the cured product having a thickness of 1 mm.

The average dispersed particle diameter of the metal oxide particles can be measured using, for example, a particle size distribution apparatus.

Furthermore, the average dispersed particle diameter is measured and calculated based on the diameters of the metal oxide particles in a dispersed state, regardless of whether the metal oxide particles are dispersed in a primary particle or secondary particle state. In addition, in the present embodiment, the average dispersed particle diameter of the metal oxide particles may be measured as an average dispersed particle diameter of the metal oxide particles to which the surface-modifying material has been attached. In the dispersion liquid, the metal oxide particles to which the surface-modifying material has been attached and the metal oxide particles to which the surface-modifying material has not been attached can be present. Therefore, the average dispersed particle diameter of the metal oxide particles is typically measured as a value in a mixed state of the particles.

The average primary particle diameter of the metal oxide particles can be optionally selected, but is, for example, preferably 3 nm or higher and 200 nm or lower, more preferably 5 nm or higher and 170 nm or lower, and still more preferably 10 nm or higher and 100 nm or lower. The average primary particle diameter of the metal oxide particles may be 5 nm or higher and 20 nm or lower, may be 5 nm or higher and 25 nm or lower, may be 50 nm or higher and 120 nm or lower, or may be 50 nm or higher and 150 nm or lower, as necessary. It is preferable that the average primary particle diameter of the metal oxide particles is within the ranges since the scattering characteristics at a wavelength of 450 nm of the cured product and the scattering characteristics at a wavelength of 600 nm of the cured product can be easily controlled.

The average primary particle diameter of the metal oxide particles can be measured by an optionally selected method. For example, the average primary particle diameter can be observed by a transmission electron microscope. For example, the metal oxide particles in the transmission electron microscope image are selected in a predetermined number, for example, 100 by a transmission electron microscope. In addition, the longest straight-line segments (longest diameters) of the respective metal oxide particles are measured, and these measurement values are arithmetically averaged to obtain the average primary particle diameter of the metal oxide particles.

Here, in a case where the metal oxide particles are agglomerated with each other, the agglomerated particle diameter of the agglomerate is not measured. The longest diameters of a predetermined number of particles (primary particles) of the metal oxide particles that configure this agglomerate are measured and used as an average primary particle diameter.

A content of the metal oxide particles in the dispersion liquid is not particularly limited as long as the metal oxide particles can be mixed with a resin component which will be described later. The content of the metal oxide particles in the dispersion liquid can be optionally selected, but is, for example, preferably 1% by mass or more and 70% by mass or less, more preferably 5% by mass or more and 50% by mass or less, still more preferably 7% by mass or more and 40% by mass or less, and particularly preferably 10% by mass or more and 30% by mass or less. The content of the metal oxide particles in the dispersion liquid may be 20% by mass or more and 40% by mass or less, or may be 25% by mass or more and 35% by mass or less, as necessary.

Such an amount of the metal oxide particles makes it possible to suppress a viscosity of the dispersion liquid from being excessively large. Therefore, it is easy to mix the metal oxide particles with the resin component which will be described later. In addition, it is possible to suppress the amount of a solvent (dispersion medium) from being excessive after the mixing of the metal oxide particles with the resin component, which makes it easy to remove the solvent.

A surface-modifying material described below is attached to the surfaces of the metal oxide particles described above. This attachment makes it possible to disperse the metal oxide particles in the resin component with desired particle diameters.

### (Surface-Modifying Materials)

The dispersion liquid of the present embodiment includes a silane compound and a silicone compound as the surface-modifying material, in which the silane compound includes a methyl group-containing silane compound. In the surface-modifying material of the present embodiment, only the silane compound and the silicone compound may be used.

The surface-modifying material is at least partially attached to the surfaces of the metal oxide particles in the dispersion liquid of the present embodiment to modify the surfaces, whereby the agglomeration of the metal oxide particles is prevented. Furthermore, the attachment improves the compatibility with the resin component.

Here, the surface-modifying material being "attached to" the metal oxide particles refers to a state where the surface-modifying material comes in contact with the metal oxide particles or bonds to the metal oxide particles through an interaction or reaction therebetween. Examples of the contact include physical adsorption. In addition, examples of the bond include an ionic bond, a hydrogen bond, a covalent bond, and the like.

In the present embodiment, the metal oxide particles may be surface-modified with at least a silane compound and a silicone compound.

The silane compound is easily attached to the vicinities of the surfaces of the metal oxide particles. On the other hand, the silicone compound has a relatively large molecular weight and mainly contributes to an improvement in the affinity with a dispersion medium or a resin component. By using such a silane compound, the dispersion stability in the resin component of the metal oxide particles is improved.

By using the silane compound and the silicone compound in combination, the dispersion stability of the metal oxide particles in the resin component is further improved, which is thus preferable.

Without inhibiting the object of the present invention, the surface-modifying material may include a component other than the silane compound and the silicone compound. Examples of such a component include a carbon-carbon unsaturated bond-containing fatty acid, specifically, a methacrylic acid, an acrylic acid, and the like.

### (Silane Compound)

The silane compound in the present embodiment includes a methyl group-containing silane compound. By subjecting the methyl group-containing silane compound to surface modification of the metal oxide particles by a production method which will be described later, the metal oxide particles in the sealing member can be suppressed from being excessively agglomerated with each other even in a case where the resin component is a methyl-based silicone resin.

From the viewpoint of having a low viscosity and making it easy to disperse the metal oxide particles in a dispersing step which will be described later, it is preferable that the methyl group-containing silane compound further includes an alkoxy group.

The number of alkoxy groups in such a silane compound including a methyl group and an alkoxy group is preferably 1 or more and 3 or less, and the number of alkoxy groups is more preferably 3. The number of alkoxy groups may be 1 or 2, as necessary. The number of carbon atoms in the alkoxy group can be optionally selected, but is preferably 1 or more and 5 or less. The number of carbon atoms may be 1 or more and 3 or less, or 2 or more and 4 or less.

Examples of such a methyl group-containing silane compound include methyltrimethoxysilane, methyltriethoxysilane, methyltripropoxysilane, methyltributoxysilane, diethoxymonomethylsilane, monoethoxydimethylsilane, dimethylchlorosilane, methyldichlorosilane, and the like. The methyl group-containing silane compound can preferably include at least one selected from the group consisting of the compounds. From the viewpoint of being easily attached to the surfaces of the metal oxide particles, it is preferable to use methyltrimethoxysilane and methyltriethoxysilane. From the viewpoint that the dispersion stability of the surface-modified metal oxide particles is improved, it is preferable to use methyltriethoxysilane.

As the silane compound, a methyl group-containing silane compound and a silane compound containing a hydrocarbon group having 2 to 5 carbon atoms may be used.

From the viewpoint that the surfaces of the metal oxide particles are densely treated, it is preferable to use only the methyl group-containing silane compound. However, in a case where the surface-modified metal oxide particles are excessively agglomerated in the sealing member, it is preferable to use the methyl group-containing silane compound and the silane compound containing a hydrocarbon group having 2 to 5 carbon atoms in combination in order to increase the compatibility with the resin component.

From the viewpoint of a low viscosity and easy dispersion of the metal oxide particles in the dispersing step which will be described later, it is preferable that the silane compound containing a hydrocarbon group having 2 to 5 carbon atoms further includes an alkoxy group.

The number of alkoxy groups in the silane compound including a hydrocarbon group and an alkoxy group is preferably 1 or more and 3 or less, and more preferably 3. The number of alkoxy groups may be 1 or 2, as necessary. The number of carbon atoms in the alkoxy group can be optionally selected, but is preferably 1 or more and 5 or less. The alkoxy group may have 1 to 3 carbon atoms or 2 to 4 carbon atoms.

The hydrocarbon group having 2 to 5 carbon atoms is not particularly limited as long as it is easily compatible with the resin component. From the viewpoint that the metal oxide particles are easily surface-modified, the number of carbon atoms is more preferably 2 or higher and 4 or lower.

The hydrocarbon group having 2 to 5 carbon atoms may be a chain-like aliphatic hydrocarbon group or may be a cyclic aliphatic hydrocarbon group.

The hydrocarbon group having 2 to 5 carbon atoms may be an alkyl group, may be an alkenyl group, or may be an alkynyl group.

As the alkyl group, for example, an ethyl group, a propyl group, a butyl group, or a pentyl group can be used. As the alkenyl group, for example, a vinyl group, an allyl group, a propenyl group, a butenyl group, or the like can be used. As the alkynyl group, an ethynyl group, a propynyl group, a butynyl group, or the like can be used.

Examples of such a silane compound containing a hydrocarbon group having 2 to 5 carbon atoms include ethyltrimethoxysilane, ethyltriethoxysilane, ethyltripropoxysilane, propyltrimethoxysilane, propyltriethoxysilane, isobutyltrimethoxysilane, vinyltrimethoxysilane, diethylchlorosilane, ethyldichlorosilane, and the like. The silane compound containing a hydrocarbon group having 2 to 5 carbon atoms may be used alone or may be used in combination of two or more kinds thereof. Among these, the silane compounds having an alkoxy group, in particular, a methoxy group are preferable since those compounds are easily attached to the metal oxide particles. Among these, the silane compound having an ethoxy group is preferable from the viewpoint that the dispersion stability of the surface-modified metal oxide particles is improved.

In a case where the methyl group-containing silane compound and the silane compound containing a hydrocarbon group having 2 to 5 carbon atoms are used as the silane compound, a mass ratio of the methyl group-containing silane compound to the silane compound containing a hydrocarbon group having 2 to 5 carbon atoms is preferably in a range of 99:1 to 35:65. The mass ratio may be 99:1 to 45:65, may be 99:1 to 50:50, or may be 99:1 to 60:40. By setting the mass ratio of the methyl group-containing silane compound to the silane compound containing a hydrocarbon group having 2 to 5 carbon atoms to be within the ranges, the metal oxide particles are densely surface modification, and even in a case of being mixed with the methyl-based silicone resin, the surface-modified metal oxide particles are suppressed from being excessively agglomerated.

A content of the silane compound in the dispersion liquid can be optionally selected and is not particularly limited, but is, for example, preferably 50 parts by mass or more and 500 parts by mass or less, more preferably 70 parts by mass or more and 400 parts by mass or less, and still more preferably 90 parts by mass or more and 300 parts by mass or less with respect to 100 parts by mass of the metal oxide particles. The content of the silane compound in the dispersion liquid may be 80 parts by mass or more and 350 parts by mass or less, or 150 parts by mass or more and 250 parts by mass or less, as necessary. In such a case, a sufficient amount of the silicone compound can be attached to the surfaces of the metal oxide particles through the silane compound. Therefore, the dispersion stability of the metal oxide particles can be improved while the dispersibility of the metal oxide particles into the resin component can be improved even in a case where the resin component is a methyl-based silicone resin.

### (Silicone Compound)

The silicone compound can be optionally selected, and examples thereof include alkoxy group-containing phenyl silicone, dimethyl silicone, methyl phenyl silicone, methyl hydrogen silicone, methyl phenyl hydrogen silicone, diphenyl hydrogen silicone, alkoxy both-terminal phenyl silicone, alkoxy both-terminal methyl phenyl silicone, alkoxy group-containing methyl phenyl silicone, alkoxy group-containing dimethyl silicone, alkoxy one-terminal trimethyl one-terminal (methyl group one-terminal) dimethyl silicone, alkoxy group-containing phenyl silicone, and the like. These silicone compounds may be used alone or may be used in combination of two or more kinds thereof.

The silicone compound may be a monomer, may be an oligomer, or may be a resin (polymer). The monomer or the oligomer is preferably used since the surface modification is easy.

Among the above-described silicone compounds, from the viewpoint of ease of a reaction and high hydrophobicity, preferred examples of the silicone compound include alkoxy group-containing phenyl silicone, dimethyl silicone, methyl phenyl silicone, alkoxy both-terminal phenyl silicone, alkoxy both-terminal methyl phenyl silicone, alkoxy group-containing methyl phenyl silicone, alkoxy group-containing dimethyl silicone, alkoxy one-terminal trimethyl one-terminal (methyl group one-terminal) dimethyl silicone, alkoxy group-containing phenyl silicone, and the like. At least one selected from the group consisting of these compounds can be included. It is more preferable that the silicone compound includes at least one selected from the group consisting of methoxy group-containing phenyl silicone, dimethyl silicone, and methoxy group-containing dimethyl silicone.

A content of the silicone compound in the dispersion liquid can be optionally selected and is not particularly limited. For example, the content of the silicone compound in the dispersion liquid is preferably, for example, 50 parts by mass or more and 500 parts by mass or less, more preferably 80 parts by mass or more and 400 parts by mass or less, and still more preferably 100 parts by mass or more and 300 parts by mass or less with respect to 100 parts by mass of the metal oxide particles. The content of the silicone compound in the dispersion liquid may be 50 parts by mass or more and 200 parts by mass or less, or 50 parts by mass or more and 150 parts by mass or less, as necessary. In such a case, a sufficient amount of the silicone compound can be attached to the surfaces of the metal oxide particles, and the dispersion stability of the metal oxide particles can be improved while the dispersibility in the resin component can be improved. Furthermore, the amount of free silicone compound can be reduced and the unintentional agglomeration of the metal oxide particles in the resin component can be suppressed.

### (Total Content of Silane Compound and Silicone Compound)

A total content of the silane compound and the silicone compound is not particularly limited and can be optionally selected. The total content of the silane compound and the silicone compound is, for example, preferably 100 parts by mass or more and 1,000 parts by mass or less, more preferably 150 parts by mass or more and 800 parts by mass or less, and still more preferably 190 parts by mass or more and 600 parts by mass or less with respect to 100 parts by mass of the metal oxide particles. The total content of the silane compound and the silicone compound may be 200 parts by mass or more and 900 parts by mass or less, or 250 parts by mass or more and 850 parts by mass or less. In a case in which the total content of the silane compound and the silicone compound is within the above-described ranges, the dispersibility of the metal oxide particles can be sufficiently improved while the amount of the free surface-modifying material is reduced.

### (Hydrophobic Solvent)

The dispersion liquid of the present embodiment includes, as a dispersion medium, a hydrophobic solvent in which the surface-modified metal oxide particles are dispersed. This hydrophobic solvent is not particularly limited as long as it can disperse the metal oxide particles to which the surface-modifying material has been attached and which can be mixed with the resin component which will be described later.

Examples of such a hydrophobic solvent include aromatic compounds, saturated hydrocarbons, unsaturated hydrocarbons, and the like. These hydrophobic solvents may be used alone or may be used in combination of two or more kinds thereof.

Examples of such a hydrophobic solvent include aromatic compounds, saturated hydrocarbons, unsaturated hydrocarbons, and the like. These hydrophobic solvents may be used alone or may be used in combination of two or more kinds thereof.

Among the above-described hydrophobic solvents, the aromatic compounds, in particular, the aromatic hydrocarbons are preferable as the hydrophobic solvent. The aromatic compounds have excellent compatibility with the resin component and contribute to an improvement of viscosity characteristics of a composition thus obtained and an improvement of qualities (a transparency, a shape, and the like) of the sealing member to be formed.

Examples of such an aromatic hydrocarbon include benzene, toluene, ethylbenzene, 1-phenylpropane, isopropylbenzene, n-butylbenzene, tert-butylbenzene, sec-butylbenzene, o-xylene, m-xylene, p-xylene, 2-ethyltoluene, 3-ethyltoluene, 4-ethyltoluene, and the like. These aromatic hydrocarbons may be used alone or may be used in combination of two or more kinds thereof.

Among the above-described aromatic hydrocarbons, at least one selected from the group consisting of toluene, o-xylene, m-xylene, p-xylene, and benzene is particularly preferably used as the hydrophobic solvent from the viewpoint of ease of handling in the stability of the dispersion liquid, the removal of the hydrophobic solvent in the composition production which will be described later, and the like.

A content of the hydrophobic solvent included in the dispersion liquid can be optionally selected, but only needs to be appropriately adjusted such that a desired concentration of solid contents is obtained. The content of the hydrophobic solvent is, for example, preferably 40% by mass or more and 95% by mass or less, more preferably 500 by mass or more and 90% by mass or less, and still more preferably 60% by mass or more and 80% by mass or less. In such a case, it is easier to mix the dispersion liquid and the resin component which will be described later, in particular, a methyl-based silicone resin. The content of the hydrophobic solvent may be 60% by mass or more and 900 by mass or less, 65% by mass or more and 85% by mass or less, or 70% by mass or more and 80% by mass or less, as necessary.

In the present embodiment, the solid content refers to a residue in a case where volatile components are removed. For example, in a case where the dispersion liquid (1.2 g) is put into a magnetic crucible and heated at 150°C for one hour on a hot plate, component that do not volatilize but remain (the metal oxide particles, the surface-modifying material, and the like) can be regarded as the solid content.

### (Hydrophilic Solvent)

The dispersion liquid of the present embodiment may include a hydrophilic solvent. The hydrophilic solvent can be included in the dispersion liquid due to, for example, a method which will be described later. Examples of such a hydrophilic solvent include alcohol-based solvents, ketone-based solvents, nitrile-based solvents, and the like. These hydrophilic solvents may be used alone or may be used in combination of two or more kinds thereof.

Examples of the alcohol-based solvent include branched or linear alcohol compounds having 1 to 4 carbon atoms and ether condensates thereof. These alcohol-based solvents may be used alone or may be used in combination of two or more kinds thereof. In addition, the alcohol compound included in the alcohol-based solvents may be any of a primary alcohol, a secondary alcohol, and a tertiary alcohol. In addition, the alcohol compound contained in the alcohol-based solvents may be any of a monohydric alcohol, a dihydric alcohol, and a trihydric alcohol. More specifically, examples of the alcohol-based solvents include methanol, ethanol, 1-propanol, isopropyl alcohol, 1-butyl alcohol, 2-butanol, isobutyl alcohol, tert-butyl alcohol, methanediol, 1,2-ethanediol, 1,2-propanediol, 1,3-propanediol, 1,2-butanediol, 1,3-butanediol, 1,4-butanediol, 2,3-butanediol, 2-butene-1,4-diol, 1,4-butynediol, glycerin, diethylene glycol, 3-methoxy-1,2-propanediol, and the like.

Examples of the ketone-based solvents include acetone, methyl ethyl ketone, methyl isobutyl ketone, cyclohexanone, and the like.

Examples of the nitrile-based solvents include acetonitrile and the like.

From the viewpoint that the affinity to both of water and the hydrophobic solvent is excellent and a mixing thereof is accelerated, it is preferable that the hydrophilic solvent includes the alcohol-based solvent. In this case, the number of carbon atoms in an alcohol compound constituting the alcohol-based solvent is preferably 1 or more and 3 or less, and more preferably 1 or more and 2 or less.

Among the hydrophilic solvents, methanol and ethanol, in particular, methanol, can be suitably used since they can sufficiently exhibit the effect of the above-described alcohol-based solvent.

In addition, the content of the hydrophilic solvent in the dispersion liquid is, for example, preferably 10% by mass or less, more preferably 7% by mass or less, still more preferably 5% by mass or less, and particularly preferably 3% by mass or less. The content of the hydrophilic solvent may be 0% by mass.

### (Other Components)

The dispersion liquid of the present embodiment may include components other than the above-described components. For example, the dispersion liquid of the present embodiment may include, as necessary, components other than the above-described components, for example, general additives such as a dispersant, a dispersion aid, an antioxidant, a flow adjuster, a viscosity improver, a pH adjuster, a preservative, and the like.

In addition, the dispersion liquid of the present embodiment may include a component which can be included due to a method which will be described later, for example, an acid, water, an alcohol, and the like.

Furthermore, in the present specification, the dispersion liquid of the present embodiment is distinguished from the composition of the present embodiment, which includes the resin component and is capable of forming a sealing member by curing. That is, even in a case where the dispersion liquid of the present embodiment includes the resin component which will be described later, the dispersion liquid does not include the resin component which will be described later in an amount enough to form a sealing member in a case of simply performing the curing. More specifically, the mass ratio of the resin component to the metal oxide particles in the dispersion liquid of the present embodiment is preferably in a range of 0:100 to 40:60, more preferably in a range of 0:100 to 30:70, and still more preferably in a range of 0:100 to 20:80 (resin component:metal oxide particles). It is particularly preferable that the dispersion liquid of the present embodiment essentially does not include the resin component which will be described later, and it is most preferable that the dispersion liquid completely does not include the resin component which will be described later.

In the dispersion liquid of the present embodiment, the surfaces of the metal oxide particles having a refractive index of 1.70 or higher and 2.00 or lower are sufficiently modified by the surface-modifying material by a production method which will be described later. Furthermore, the metal oxide particles modified in this manner have excellent affinity even with a methyl-based silicone resin, and can be dispersed at a desired dispersion state with excellent scattering characteristics even in the methyl-based silicone resin.

In comparison with a phenyl-based silicone resin in the related art, the methyl-based silicone resin easily causes the surface-modified metal oxide particles to be agglomerated. However, in a case where the metal oxide particles have a refractive index of 1.70 or higher and 2.00 or lower, the scattering characteristics at a wavelength of 450 nm of the cured product and the scattering characteristics at a wavelength of 600 nm of the cured product are more likely to be within desired ranges due to the ease of agglomeration. As a result, the sealing member formed using the dispersion liquid of the present embodiment can improve the brightness of the light emitting device.

### (Method for Producing Dispersion Liquid)

The method for producing a dispersion liquid of the present embodiment includes a step B of mixing a silane compound and metal oxide particles to obtain a liquid mixture,
a step C of dispersing the metal oxide particles in the liquid mixture to obtain a first dispersion liquid in which the metal oxide particles are dispersed,
a step D of adding a hydrophobic solvent to the first dispersion liquid to obtain a second dispersion liquid, and
a step E of adding a silicone compound to the second dispersion liquid to obtain a third dispersion liquid.

The metal oxide particles have a refractive index of 1.70 or more and 2.00 or less,
the silane compound includes a methyl group-containing silane compound,
in the step B, a content of the metal oxide particles in the liquid mixture is 10% by mass or more and 49% by mass or less, and a total content of the silane compound and the metal oxide particles in the liquid mixture is 650 by mass or more and 98% by mass or less, and
the step D is any of a step d1 of heating the first dispersion liquid and then adding the hydrophobic solvent to the first dispersion liquid at a rate at which the metal oxide particles are not agglomerated, a step d2 of adding the hydrophobic solvent to the first dispersion liquid at a rate at which the metal oxide particles are not agglomerated, while heating the first dispersion liquid, or a step d3 of adding the hydrophobic solvent to the first dispersion liquid at a rate at which the metal oxide particles are not agglomerated, and then heating the first dispersion liquid.

The silane compound may contain a silane compound containing a hydrocarbon group having 2 to 5 carbon atoms, in addition to the methyl group-containing silane compound.

In a case where the silane compound contains the silane compound containing a hydrocarbon group having 2 to 5 carbon atoms, it is preferable that the methyl group-containing silane compound and the silane compound containing a hydrocarbon group having 2 to 5 carbon atoms are at a mass ratio of 99:1 to 35:65. The mass ratio may be 99:1 to 45:65, may be 99:1 to 50:50, or may be 99:1 to 60:40.

The total content of the silane compound and the metal oxide particles can also be evaluated by the solid contents.

The total content of the silane compound and the metal oxide particles does not include an alcohol that is generated by the hydrolysis of a silane compound which will be described later. That is, the total content of the silane compound and the metal oxide particles means a total content of the silane compound, the hydrolyzed silane compound, and the metal oxide particles. Furthermore, it is needless to say that the total content is a value including the content of the metal oxide particles attached to the silane compound.

In addition, in the present embodiment, a step A (hydrolyzing step) of mixing the silane compound and water to obtain a hydrolysis liquid including a hydrolyzed silane compound may be provided before each of the steps.

Hereinafter, each step for obtaining a dispersion liquid of the present embodiment will be described in detail.

### (Step A (Hydrolyzing Step))

In the hydrolyzing step, at least the silane compound and water are mixed to obtain a hydrolysis liquid including a hydrolyzed silane compound. By using the liquid mixture obtained by hydrolyzing at least a part of the silane compound in advance as described above, the silane compound is easily attached to the metal oxide particles in a dispersing step which will be described later.

As the silane compound, the methyl group-containing silane compound among the above-described silane compounds may be used alone or may be used in combination of two or more kinds thereof.

In addition, a content of the silane compound in the hydrolysis liquid is not particularly limited. The hydrolysis product can be a residue obtained by removing other components from the hydrolysis liquid, but, for example, the content of the hydrolysis product is preferably 60% by mass or more and 99% by mass or less, more preferably 70% by mass or more and 97% by mass or less, and still more preferably 80% by mass or more and 95% by mass or less. The content of the silane compound in the hydrolysis liquid may be 85% by mass or more and 95% by mass or less, or 87% by mass or more and 93% by mass or less, as necessary.

In a case where two or more kinds of the silane compounds are used in combination, the hydrolysis may be independently performed with each of the silane compounds or the hydrolysis may be performed in a state where two or more kinds of silane compounds are mixed.

Furthermore, in the hydrolyzing step, a surface-modifying material other than the silane compound may be contained in the hydrolysis liquid.

In addition, in the hydrolyzing step, the hydrolysis liquid includes water. Water serves as a substrate for the hydrolysis reaction of a surface-modifying material such as a silane compound and the like.

A content of water in the hydrolysis liquid is not particularly limited and can be optionally selected. For example, the content of water can be appropriately set corresponding to the amount of the silane compound. For example, the amount of water to be added to the hydrolysis liquid is preferably 0.5 mol or more and 5 mol or less, more preferably 0.6 mol or more and 3 mol or less, and still more preferably 0.7 mol or more and 2 mol or less with respect to 1 mol of the silane compound. In such a case, it is possible to more reliably prevent the occurrence of the agglomeration of the metal oxide particles in a dispersion liquid to be produced due to an excess amount of water while allowing the hydrolysis reaction of the silane compound to sufficiently proceed.

Alternatively, the content of water in the hydrolysis liquid is, for example, preferably 1% by mass or more and 20% by mass or less, more preferably 1% by mass or more and 15% by mass or less, and still more preferably 1% by mass or more and 10% by mass or less.

In addition, a catalyst may be added to the hydrolysis liquid together with the silane compound and water. As the catalyst, for example, an acid or a base can be used.

The acid catalyzes the hydrolysis reaction of the silane compound in the hydrolysis liquid. On the other hand, the base catalyzes a condensation reaction between the hydrolyzed silane compound and functional groups on the surfaces of the metal oxide particles, for example, hydroxyl groups or silanol groups. These reactions make it easy for silane compounds, including the silane compound, to be attached to the metal oxide particles in the dispersing step (step C) which will be described later, and the dispersion stability of the metal oxide particles is thus improved.

Here, the "acid" refers to an acid based on a so-called Bronsted-Lowry definition, and refers to a substance that donates a proton in the hydrolysis reaction of a surface-modifying material such as a silane compound and the like. In addition, the "base" refers to a base based on the so-called Bronsted-Lowry definition, and refers herein to a substance that accepts a proton in the hydrolysis reaction of the surface-modifying material such as the silane compound and the like, and the following condensation reaction.

The acid is not particularly limited as long as it is capable of supplying a proton in the hydrolysis reaction of the silane compound, and can be optionally selected. Examples of the acid include inorganic acids such as hydrochloric acid, hydrobromic acid, hydroiodic acid, sulfuric acid, nitric acid, boric acid, phosphoric acid, and the like; and organic acids such as acetic acid, citric acid, formic acid, and the like. These acids may be used alone or may be used in combination of two or more kinds thereof.

The base is not particularly limited as long as it is capable of accepting a proton in the hydrolysis reaction of the silane compound, and can be optionally selected. Examples of the base include sodium hydroxide, potassium hydroxide, barium hydroxide, calcium hydroxide, ammonia, amines, and the like. These bases may be used alone or may be used in combination of two or more kinds thereof.

Among the above-described catalysts, the acid is preferably used as the catalyst. As the acid, the inorganic acid is preferable, and hydrochloric acid is more preferable from the viewpoint of the acidity.

A content of the catalyst in the hydrolysis liquid is not particularly limited, but is, for example, preferably 10 ppm or more and 1,000 ppm or less, more preferably 20 ppm or more and 800 ppm or less, and still more preferably 30 ppm or more and 600 ppm or less. In such a case, the side reaction of the silane compound can be suppressed while the hydrolysis of the silane compound can be sufficiently accelerated. Furthermore, the content of the catalyst in the hydrolysis liquid may be 0.1 ppm or more and 100 ppm or less, or 1 ppm or more and 10 ppm or less. In addition, for example, in a case where an acid such as hydrochloric acid (1 N) and the like is used as the catalyst, the amount of the acid may be 0.001 parts by mass or more and 5 parts by mass or less, may be 0.001 parts by mass or more and 3 parts by mass or less, may be 0.005 parts by mass or more and 1 part by mass or less, or may be 0.005 parts by mass or more and 0.1 parts by mass or less with respect to 100 parts by mass of the hydrolysis liquid.

In addition, the hydrolysis liquid may include a hydrophilic solvent, as necessary. The hydrophilic solvent is capable of further accelerating the hydrolysis reaction of the silane compound by accelerating the mixing of water and the silane compound in the hydrolysis liquid.

Examples of such a hydrophilic solvent include a variety of the above-described hydrophilic solvents which can be included in the dispersion liquid. A content of the hydrophilic solvent in the hydrolysis liquid may be 0% by mass or more and 85% by mass or less, or may be 10% by mass or more and 70% by mass or less.

Among the above-described hydrophobic solvents, from the viewpoint of having excellent affinity to both water and hydrophobic solvents and accelerating the mixing thereof, the hydrophilic solvent preferably includes at least one selected from the group consisting of alcohol-based solvents, and more preferably includes at least one selected from the group consisting of methanol and ethanol.

In addition, a content of the hydrophilic solvent in the hydrolysis liquid is not particularly limited, but is, for example, preferably 85% by mass or less, more preferably 80% by mass or less, and still more preferably 75% by mass or less. Within the ranges, the content of the silane compound and water in the hydrolysis liquid can be sufficiently increased.

The content of the hydrophilic solvent in the hydrolysis liquid may be 40% by mass or less, or 20% by mass or less. In addition, the content of the hydrophilic solvent in the hydrolysis liquid is, for example, preferably 10% by mass or more, and more preferably 15% by mass or more. Within the ranges, the mixing of the silane compound and water can be further accelerated, and as a result, the hydrolysis reaction of the silane compound can proceed efficiently. Furthermore, the hydrolysis liquid may not include any hydrophilic solvents excluding a compound derived from the hydrolysis reaction. That is, only a hydrophilic solvent that is a compound derived from the hydrolysis reaction may be included.

In the present embodiment, in the case of using a silane compound having an alkoxy group as the silane compound, the silane compound is hydrolyzed, and therefore, an alcohol compound derived from the alkoxy group is included in the liquid mixture. Since the hydrolysis reaction also progresses with adsorbed water of the metal oxide particles, the hydrolysis reaction can occur in any of the step A to the step E. Therefore, in this case, as long as a step of removing the alcohol compound is not provided, the alcohol compound is included in a dispersion liquid thus obtained. Accordingly, the step of removing the alcohol compound with an evaporator or the like may be appropriately provided.

In the hydrolyzing step, the hydrolysis liquid may be held at a certain temperature optionally selected for a predetermined time after preparing a hydrolysis liquid. This can further accelerate the hydrolysis of the silane compound.

In this treatment, the temperature of the hydrolysis liquid is not particularly limited, can be optionally selected, and can be appropriately changed depending on the kind of the silane compound. For example, the temperature is preferably 5°C or higher and 65°C or lower, more preferably 20°C or higher and 65°C or lower, and still more preferably 30°C or higher and 60°C or lower. The temperature may be 40°C or higher and 75°C or lower, or 50°C or higher and 70°C or lower, as necessary.

In addition, the holding time at the temperature is not particularly limited, but is, for example, preferably 10 minutes or longer and 180 minutes or shorter, and more preferably 30 minutes or longer and 120 minutes or shorter. The holding time may be 15 minutes or longer and 60 minutes or shorter, or 20 minutes or longer and 40 minutes or shorter, as necessary.

Furthermore, the hydrolysis liquid may be appropriately stirred while the hydrolysis liquid is being held.

### (Step B (Mixing Step))

In the mixing step, the silane compound and the metal oxide particles are mixed to obtain a liquid mixture. In the mixing step, water or a catalyst may be mixed, in addition to the silane compound and the metal oxide particles. Furthermore, in a case where the hydrolysis liquid is obtained by the above-described hydrolyzing step, a liquid mixture is obtained by mixing the hydrolysis liquid with the metal oxide particles.

Furthermore, the hydrolysis liquid and the metal oxide particles are mixed such that a content of the metal oxide particles in the liquid mixture is 10% by mass or more and 49% by mass or less, and a total content of the silane compound and the metal oxide particles is 65% by mass or more and 98% by mass or less.

As described above, in the present embodiment, the total content of the silane compound and the metal oxide particles in the liquid mixture is extremely large. In addition, an organic solvent and a dispersion medium such as water and the like, which have been considered to be essential in the related art, are not included in the liquid mixture, or mixed only in an extremely small amount, as compared with the related art. Alternatively, a small amount of an unavoidable alcohol compound is contained due to the hydrolysis. Even in such a case, by undergoing the dispersing step, the metal oxide particles can be uniformly dispersed in the liquid mixture, while uniform attachment of the silane compound to the metal oxide particles (surface modification) is achieved.

To be more specific, generally, in a case where metal oxide particles are surface-modified with a silane compound in a liquid phase, it is common to mix not only the metal oxide particles and the silane compound but also a dispersion medium to obtain a liquid mixture, which is subjected to a dispersion treatment using a disperser. Furthermore, in a case where the metal oxide particles which have been surface-modified by such a method are mixed with a methyl-based silicone resin, the metal oxide particles cannot be sufficiently dispersed in the methyl-based silicone resin and are thus agglomerated, resulting in a problem of the occurrence of turbidity such as white turbidity in the methyl-based silicone resin, and the like. In such a case, the metal oxide particles to be added do not sufficiently exhibit intended performance.

The dispersion medium is typically added for the purpose of decreasing the viscosity of the liquid mixture, uniformly dispersing the metal oxide particles, and uniformly modifying the surfaces of the metal oxide particles with the silane compound. In the related art, in a case where the dispersion medium is not used, it is considered that the viscosity of the dispersion liquid increases, and as a result, the silane compound is not sufficiently attached to the surfaces of the metal oxide particles. Surprisingly, the present inventors have found that it is possible to uniformly disperse the metal oxide particles in a dispersion liquid to be obtained and uniformly modify the metal oxide particles with a silane compound by directly dispersing the metal oxide particles at a high concentration of the silane compound while using no dispersion medium or only a small amount of a dispersion medium that has been regarded as essential in the related art as described above.

The silane compound has a low molecular weight and a relatively low viscosity. Furthermore, the silane compound is hydrolyzed in the above-described hydrolyzing step, and thus, has a favorable property of being attached to the metal oxide particles. Therefore, the silane compound is extremely suitable for the dispersion of the metal oxide particles in the surface-modifying material at a high concentration.

In a case where the total content of the silane compound and the metal oxide particles is less than 65% by mass, the amount of the components other than the two components, for example, the dispersion medium is too large. Therefore, the silane compound cannot be sufficiently attached to the surfaces of the metal oxide particles in a dispersing step (step C) which will be described later. As a result, a large number of hydroxyl groups remain on the surfaces of the metal oxide particles, and in a case where a dispersion liquid obtained afterwards is mixed with a hydrophobic material, the metal oxide particles are agglomerated, and the turbidity of the hydrophobic material occurs. The total content of the silane compound and the metal oxide particles only needs to be 65% by mass or more, but is preferably 70% by mass or more, and more preferably 75% by mass or more. The total content of the silane compound and the metal oxide particles may be 80% by mass or more, 85% by mass or more, 90% by mass or more, or 92% by mass or more, as necessary.

In contrast, in a case where the total content of the silane compound and the metal oxide particles is more than 98% by mass, the viscosity of the liquid mixture is too high, and in the dispersing step (step C) which will be described later, the silane compound cannot be sufficiently attached to the surfaces of the metal oxide particles. The total content of the silane compound and the metal oxide particles only needs to be 98% by mass or less, but is preferably 97% by mass or less, and more preferably 95% by mass or less. The total content of the silane compound and the metal oxide particles may be 90% by mass or less, 85% by mass or less, 80% by mass or less, or 75% by mass or less, as necessary.

In addition, as described above, the content of the metal oxide particles in the liquid mixture is 10% by mass or more and 49% by mass or less. With the content within such ranges, the amount of the silane compound with respect to the metal oxide particles can be controlled to be within an appropriate range. Thus, the silane compound can be uniformly attached to the surfaces of the metal oxide particles and an increase in the viscosity of the liquid mixture can be suppressed.

On the other hand, in a case where the content of the metal oxide particles in the liquid mixture is less than 10% by mass, the amount of the silane compound is excessive with respect to the metal oxide particles, and thus, the excess silane compound induces the agglomeration of the metal oxide particles in the obtained dispersion liquid. A content of the metal oxide particles in the liquid mixture is preferably 20% by mass or more, more preferably 23% by mass or more, still more preferably 26% by mass or more, and particularly preferably 30% by mass or more.

In addition, in a case where the content of the metal oxide particles is more than 49% by mass, the amount of the silane compound is insufficient with respect to the metal oxide particles and a sufficient amount of the silane compound is not attached to the metal oxide particles. In addition, as a result of the excessively high content of the metal oxide particles, the viscosity of the liquid mixture is excessively increased, and in the dispersing step (step C) which will be described later, the metal oxide particles cannot be sufficiently dispersed. The content of the metal oxide particles in the liquid mixture is preferably 45% by mass or less, and more preferably 40% by mass or less. The content of the metal oxide particles in the liquid mixture is still more preferably 38% by mass or less, and particularly preferably 36% by mass or less. A content of the metal oxide particles in the liquid mixture may be 34% by mass or less.

A content of the silane compound with respect to the content of the metal oxide particles in the liquid mixture is not particularly limited, but is, for example, preferably 100% by mass or more and 800% by mass or less, more preferably 140% by mass or more and 600% by mass or less, still more preferably 180% by mass or more and 400% by mass or less, and particularly preferably 200% by mass or more and 270% by mass or less with respect to the amount of the metal oxide particles. In such a case, the amount of the silane compound with respect to the metal oxide particles can be controlled to be within an appropriate range and the silane compound can be uniformly attached to the surfaces of the metal oxide particles.

In addition, in the mixing step, an organic solvent may be further mixed with the liquid mixture. In a case where the organic solvent is mixed with the liquid mixture, it is possible to control the reactivity of the surface-modifying material, and it is possible to control the degree of attachment of the surface-modifying material to the surfaces of the metal oxide particles. Furthermore, it is possible to adjust the viscosity of the liquid mixture with the organic solvent.

Examples of such an organic solvent include the hydrophobic solvents and the hydrophilic solvents, mentioned as the above-described dispersion medium of the composition according to the present embodiment. These organic solvents may be used alone or may be used in combination of two or more kinds thereof.

A content of the organic solvent in the liquid mixture is not particularly limited as long as it satisfies the contents of the metal oxide particles and the silane compound described above. Furthermore, it is needless to say that the organic solvent may not be included in the liquid mixture.

A mixing time and a mixing temperature in the mixing step can be optionally selected. However, for example, the mixing may be performed at room temperature (25°C), and the materials may be well mixed and then stirred for approximately 0 to 600 seconds.

### (Step C (Dispersing Step))

In the dispersing step, the metal oxide particles are dispersed in the liquid mixture to obtain a first dispersion liquid in which the metal oxide particles are dispersed. In the present embodiment, the metal oxide particles are dispersed in the hydrolyzed silane compound at a high concentration. Therefore, in the first dispersion liquid thus obtained, the silane compound is relatively uniformly attached to the surfaces of the metal oxide particles, and the metal oxide particles are relatively uniformly dispersed.

The metal oxide particles can be dispersed by a well-known dispersion method, for example, a use of a disperser. As the disperser, for example, a bead mill, a ball mill, a homogenizer, a disperser, a stirrer, or the like is preferably used. The step C is preferably a step of subjecting only the mixture obtained in the step B to a dispersion treatment.

Here, in the dispersing step, the metal oxide particles are preferably dispersed in the liquid mixture by imparting a minimum necessary energy without imparting excessive energy such that the particle diameter (dispersed particle diameter) of the metal oxide particles in the dispersion liquid is substantially uniform.

The dispersion time can be optionally selected depending on the conditions, and is, for example, 3 hours to 20 hours, preferably 4 hours to 18 hours, more preferably 6 hours to 16 hours, and still more preferably 8 hours to 14 hours. It should be noted that the dispersion time is not limited to these. The dispersion temperature can be optionally selected, but is, for example, 10°C to 50°C, preferably 20°C to 40°C, and more preferably 30°C to 40°C. It should be noted that the dispersion temperature is not limited thereto.

Furthermore, a difference of the dispersing step C from the mixing step B may mean that the dispersion is continuously performed for a certain time.

The scattering characteristics at a wavelength of 450 nm of the cured product and the scattering characteristics at a wavelength of 600 nm of the cured product can be relatively easily controlled under the dispersion conditions. In a case where the scattering fraction at a wavelength of 450 nm of the cured product is small, the dispersion time only needs to be shortened. On the other hand, in a case where the scattering fraction at a wavelength of 450 nm of the cured product is large, the dispersion time only needs to be increased. In a case where an adjustment cannot be made using only the dispersion time, the type and the ratio of the metal oxide particles or the surface-modifying material only needs to be adjusted such that the scattering fraction at a wavelength of 450 nm of the cured product and the scattering fraction at a wavelength of 600 nm of the cured product are appropriate. In particular, it is preferable to adjust the refractive index of the metal oxide particles.

### (Step D (Adding Step (First Adding Step)))

In the adding step, a hydrophobic solvent is added to the first dispersion liquid obtained in the step C (dispersing step), and the first dispersion liquid is adjusted to a desired concentration of solid contents.

The first dispersion liquid obtained in the dispersing step has a high concentration of solid contents. Therefore, the viscosity is high and the handleability is poor. However, in a case where the hydrophobic solvent is simply added to the obtained first dispersion liquid in order to decrease the concentration of solid contents, the hydrophobicity of the particle surface is low, and therefore, the particles are agglomerated and a uniform dispersion liquid is not obtained.

Therefore, as a result of the studies, the present inventors have found that the obtained first dispersion liquid can be heated and the hydrophobic solvent can be gradually added thereto to adjust the dispersion liquid to have a low concentration of solid contents. By performing this operation, an extremely excellent effect can be obtained.

A mechanism thereof is presumed to be as follows.

By heating the first dispersion liquid, the polymerization of the silane compound attached to the metal oxide particles proceeds, and thus, the hydrophobicity of the particle surface is improved. Furthermore, the metal oxide particles are agglomerated even in a case where a polymerization reaction of the silane compound proceeds excessively. Therefore, a hydrophobic solvent is gradually added to the first dispersion liquid in which the polymerization reaction is proceeding. By performing such an addition, the surface is gradually hydrophobized while suppressing an excessive polymerization reaction, and the hydrophobic solvent can be gradually mixed.

That is, the hydrophobic solvent is added in an amount such that the metal oxide particles are not agglomerated, and the polymerization reaction of the silane compound is allowed to proceed to an extent to make the addition amount of the hydrophobic solvent compatible with the hydrophobic solvent. This makes it possible to obtain a dispersion liquid adjusted to a desired concentration of solid contents.

As described above, the hydrophobic solvent only needs to be gradually added so that the metal oxide particles are not agglomerated. Therefore, the first dispersion liquid obtained in the dispersing step may be heated before the hydrophobic solvent is added, or the first dispersion liquid may be heated after the hydrophobic solvent is added, or the heating of the first dispersion liquid and the addition of the hydrophobic solvent may be performed at the same time.

That is, to be more specifically, the adding step may be a step d1 of heating the first dispersion liquid and then adding the hydrophobic solvent to the first dispersion liquid at a rate at which the metal oxide particles are not agglomerated, a step d2 of adding the hydrophobic solvent to the first dispersion liquid at a rate at which the metal oxide particles are not agglomerated, while heating the first dispersion liquid, or a step d3 of adding the hydrophobic solvent to the first dispersion liquid at a rate at which the metal oxide particles are not agglomerated, and then heating the first dispersion liquid.

In the step d1, in a case of adding the metal oxide particles, the heating of the dispersion liquid may be continued or stopped. The temperature of the dispersion liquid may be constant or the temperature of the dispersion liquid may vary. It is preferable that the temperature of the dispersion liquid is maintained constant. In the step d2, in a case of adding the metal oxide particles, the temperature of the dispersion liquid may be constant or the temperature of the dispersion liquid may vary.

The hydrophobic solvent may be added continuously or intermittently in two or more portions. In a case of adding the solution intermittently, the number of times of addition is not limited, but for example, the solution can be added in 2 to 6 portions, or 3 to 5 portions. In a case of adding the hydrophobic solvent a plurality of times, the amount of the hydrophobic solvent may be the same or may be changed.

The rate at which the metal oxide particles are not agglomerated is not particularly limited. The rate or the proportion of the addition of the hydrophobic solvent can be optionally selected. For example, the hydrophobic solvent only needs to be continuously added at an addition rate such that the concentration of solid contents is lowered within a range of 3% by mass or more and 20% by mass or less in one hour. In other words, after the hydrophobic solvent has been continuously added for one hour, a difference between the concentration of solid contents of the dispersion liquid before the addition and the concentration of solid contents of the dispersion liquid after the addition may be in a range of 3% by mass or more and 20% by mass or less. The amount of the hydrophobic solvent to be added only needs to be appropriately adjusted such that the amount of the hydrophobic solvent is increased in a case where the heating temperature is high, and the amount of the hydrophobic solvent is decreased in a case where the heating temperature is low.

As described above, the rate and the proportion of the addition of the hydrophobic solvent can be optionally selected. For example, the hydrophobic solvent only needs to be stepwise added every 30 minutes, every hour, or every two hours such that the concentration of solid contents is decreased within a range of 3% by mass or more and 20% by mass or less. The amount of the hydrophobic solvent to be added at one time only needs to be appropriately adjusted such that the amount of the hydrophobic solvent is increased in a case where the heating temperature is high, and the amount of the hydrophobic solvent to be added at one time is decreased in a case where the heating temperature is low. In this case, the addition time or the addition number of the hydrophobic solvent may also be preferably adjusted.

The heating temperature is not particularly limited as long as it is a temperature at which the polymerization reaction of the silane compound proceeds. The heating temperature is, for example, preferably 35°C or higher and 80°C or lower. The heating temperature may be 40°C or higher and 75°C or lower, 45°C or higher and 70°C or lower, or 50°C or higher and 65°C or lower. By setting the heating temperature to 35°C or higher, a polymerization reaction of the silane compound can proceed. On the other hand, by setting the heating temperature to 80°C or lower, the agglomeration of the metal oxide particles due to a rapid reaction of the silane compound can be suppressed.

The heating time only needs to be appropriately performed until the adjustment of the concentration of solid contents is completed. The heating time is, for example, preferably 4 hours or higher and 12 hours or lower. By setting the heating time to 4 hours or longer, the polymerization reaction of the silane compound proceeds and the silane compound can be mixed with the hydrophobic solvent. On the other hand, by setting the heating time to 12 hours or lower, the agglomeration of the metal oxide particles due to the excessive progress of the polymerization reaction of the silane compound can be suppressed.

The hydrophobic solvent is not particularly limited as long as it is compatible with a material to be mixed with the dispersion liquid of the present embodiment. Examples of the hydrophobic solvent include aromatic solvents, saturated hydrocarbons, unsaturated hydrocarbons, and the like. These hydrophobic solvents may be used alone or may be used in combination of two or more kinds thereof. Among these, the aromatic compounds, in particular, the aromatic hydrocarbons are preferable. The aromatic solvents have excellent compatibility with the methyl-based silicone resin, and contribute to an improvement in the viscosity characteristics of a composition thus obtained and an improvement in qualities (a transparency, a shape, and the like) of a sealing member to be formed.

Examples of the aromatic hydrocarbon include benzene, toluene, ethylbenzene, 1-phenylpropane, isopropylbenzene, n-butylbenzene, tert-butylbenzene, sec-butylbenzene, o-xylene, m-xylene, p-xylene, 2-ethyltoluene, 3-ethyltoluene, 4-ethyltoluene, and the like. These aromatic hydrocarbons may be used alone or may be used in combination of two or more kinds thereof.

Among those, from the viewpoint of ease of handling in the stability of the dispersion liquid, the removal of the dispersion medium in the composition production which will be described later, and the like, at least one selected from the group consisting of toluene, o-xylene, m-xylene, p-xylene, and benzene is particularly preferably used as the aromatic hydrocarbon.

A content of the hydrophobic solvent included in the final dispersion liquid only needs to be appropriately adjusted to obtain a desired concentration of solid contents. The content of the hydrophobic solvent is, for example, preferably 40% by mass or more and 95% by mass or less, more preferably 50% by mass or more and 90% by mass or less, and still more preferably 60% by mass or more and 80% by mass or less.

A second dispersion liquid adjusted to a desired concentration of solid contents is obtained by the first adding step. The handleability of the dispersion liquid in the following steps is improved by using the second dispersion liquid.

### (Step F (Removing Step))

In the present embodiment, a step F of removing an alcohol produced by the hydrolysis may be provided between the step D and the step E.

It is presumed that the production efficiency of the steps described below is improved by providing the removing step.

A method for removing the solvent is not particularly limited but, for example, an evaporator can be used. The removing step may be performed until the alcohol is completely removed, or the alcohol may remain in an amount of approximately 5% by mass.

### (Step E (Second Adding Step))

Next, the metal oxide particles are treated with a silicone compound to obtain a third dispersion liquid. As described above, the silane compound is relatively uniformly attached to the surfaces of the metal oxide particles in the dispersing step. Therefore, the silicone compound can be relatively uniformly attached to the surfaces of the metal oxide particles through the silane compound.

In the second adding step, first, the second dispersion liquid and the silicone compound are mixed to obtain a treatment liquid. Next, the treatment liquid may be held at a certain temperature for a predetermined time. In such a case, the attachment of the silicone compound to the metal oxide particles can be further accelerated.

Examples of the silicone compound include the above-described silicone compounds. These silicone compounds may be used alone or may be used in combination of two or more kinds thereof.

The silicone compound can be mixed with the second dispersion liquid such that the content of the silicone compound in the third dispersion liquid is, for example, preferably 50% by mass or more and 500% by mass or less, more preferably 80% by mass or more and 400% by mass or less, and still more preferably 100% by mass or more and 300% by mass or less with respect to the metal oxide particles. In such a case, a sufficient amount of the silicone compound can be attached to the surfaces of the metal oxide particles, and the dispersion stability of the metal oxide particles and the dispersibility into the methyl-based silicone resin can be improved at the same time. Furthermore, the amount of the free silicone compound can be reduced and unintentional agglomeration of the metal oxide particles in the methyl-based silicone resin can be suppressed.

In the second adding step, the holding temperature is not particularly limited and can be appropriately changed depending on the type of the silicone compound. However, the holding temperature is preferably 40°C or higher and 130°C or lower, and more preferably 50°C or higher and 120°C or lower.

In addition, the holding time is not particularly limited, but is, for example, preferably 1 hour or higher and 24 hours or lower, and more preferably 2 hours or higher and 20 hours or lower.

Furthermore, during the holding, the second dispersion liquid may be appropriately stirred.

In addition, in the second adding step, the treatment with the silicone compound may be performed a plurality of times. For example, by performing the treatment with the silicone compound, using different kinds of silicone compounds, a plurality of times, the control of the surface state of the metal oxide particles in accordance with the kind of the methyl-based silicone resin is easier.

In addition, in the second adding step, the concentration of solid contents may be measured after the treatment with the silicone compound, and a hydrophobic solvent may be added in order to achieve a desired concentration of solid contents. It is easy to mix with a resin component which will be described later by lowering the concentration of solid contents.

As described above, the third dispersion liquid can be obtained by treating the metal oxide particles with the silicone compound.

As necessary, a step G of mixing the third dispersion liquid obtained in the step E and methyl phenyl silicone so that a ratio of a total mass of the metal oxide particles and the surface-modifying material to a mass of methyl phenyl silicone is 7:93, thereby obtaining a mixture, curing the mixture to form a cured product having a thickness of 1 mm, and confirming whether the cured product has a scattering fraction of 17% or more and 38% or less at a wavelength of 450 nm and a value obtained by dividing the scattering fraction at the wavelength of 450 nm of the cured product by the scattering fraction at a wavelength of 600 nm of the cured product is 1.25 or higher may be provided after the step E. Furthermore, in a case where the scattering fraction and the value confirmed in the step G are within the desired ranges, the method may further include a step H of selecting the dispersion liquid.

The metal oxide particles are uniformly dispersed in the dispersion liquid produced using the production method, and the surfaces of the metal oxide particles are uniformly and sufficiently modified with the silane compound and the silicone compound. Furthermore, the metal oxide particles having a refractive index of 1.70 or higher and 2.00 or lower, which have been modified as described above, have excellent affinity with the methyl-based silicone resin, and can be relatively uniformly dispersed in a size at which desired scattering characteristics are obtained in the methyl-based silicone resin. Therefore, even in a case where the metal oxide particles are dispersed in the methyl-based silicone resin, the brightness of the light emitting device can be improved with a use of the methyl-based silicone resin as the sealing member.

Furthermore, components other than the above-described components, for example, general additives such as a dispersant, a dispersion aid, an antioxidant, a flow adjuster, a viscosity improver, a pH adjuster, a preservative, and the like may be mixed with the dispersion liquid of the present embodiment, as necessary. These can be added in an optional step, as necessary.

### (Composition)

The composition of the present embodiment is a mixture of the dispersion liquid and the resin component described above. Therefore, the composition of the present embodiment includes a resin component, that is, at least one of a resin and a precursor of the resin, in addition to the above-described metal oxide particles having a refractive index of 1.70 or higher and 2.00 or lower, which have been surface-modified with the silane compound and silicone compound.

The composition of the present embodiment is cured as described below and thus used as a sealing member of a light emitting element. The composition of the present embodiment can improve the brightness of light of a light emitting device in a case where being used for a sealing member, by incorporating the above-described metal oxide particles contributing to an improvement in the refractive index and the transparency.

Furthermore, the composition of the present embodiment includes the above-described metal oxide particles having a refractive index of 1.70 or higher and 2.00 or lower, which have been surface-modified with the silane compound and the silicone compound. Therefore, even in a case where a methyl-based silicone resin is included as the resin component, excessive agglomeration of the metal oxide particles is suppressed and a decrease in transparency is suppressed. Therefore, in a case where the composition of the present embodiment is used for a sealing member, the brightness of light of a light emitting device can be improved.

In the composition of the present embodiment, a content of the metal oxide particles is not particularly limited as long as it is such an amount that the scattering fraction at a wavelength of 450 nm of the cured product and the scattering fraction at a wavelength of 600 nm of the cured product are desired values. For example, the content of the surface-modified metal oxide particles is preferably 2% by mass or more and 11% by mass or less, and more preferably 3% by mass or more and 10% by mass or less with respect to the total content of the surface-modified metal oxide particles and the resin component.

In addition, a content of the surface-modifying material such as the silane compound, the silicone compound, and the like in the composition of the present embodiment can correspond to the content in the dispersion liquid of the present embodiment.

The average dispersed particle diameter of the surface-modified metal oxide particles in the composition of the present embodiment is not particularly limited as long as desired scattering characteristics are obtained, and the average dispersed particle diameter may be, for example, 30 nm or higher and 1,000 nm or lower, 50 nm or higher and 800 nm or lower, or 60 nm or higher and 700 nm or lower.

In addition, the average dispersed particle diameter of the surface-modified metal oxide particles is not particularly limited as long as it is a value of the particle diameter in a case where the composition has been cured as the sealing member is 60 nm or higher and 1,000 nm or lower. Furthermore, the average dispersed particle diameter in a case where the composition has been cured means a secondary particle diameter (agglomerated particle diameter) in a case where the metal oxide particles are agglomerated with each other, that is, in a case where secondary particles are formed.

The agglomeration state of the surface-modified metal oxide particles in the cured product varies depending on a combination of the metal oxide particles, the surface-modifying material, the resin component, and the particles of a fluorescent body, and on the curing conditions of the composition. Therefore, the average dispersed particle diameter of the metal oxide particles in the composition only needs to be adjusted while checking the scattering characteristics at a wavelength of 450 nm and the scattering characteristics at a wavelength of 600 nm in a case where the composition is cured. Examples of a method for adjusting the average dispersed particle diameter of the metal oxide particles in the composition include a method for adjusting the average dispersed particle diameter of the metal oxide particles in the dispersion liquid.

The average dispersed particle diameter of the surface-modified metal oxide particles in the composition can be measured using, for example, a particle size distribution apparatus.

### (Resin Component)

The resin component is a main component in the composition of the present embodiment. The resin component is cured to seal a light emitting element in a case where the composition of the present embodiment is used as a sealing material. As a result, the resin component prevents deterioration factors from external environments such as moisture, oxygen, and the like from reaching the light emitting element. In addition, in the present embodiment, a cured product that is obtained from the resin component is basically transparent and can transmit light emitted from a light emitting element.

Such a resin component is not particularly limited as long as it can be used as a sealing material. For example, resins such as a silicone resin, an epoxy resin, and the like may be used alone or in combination of two or more kinds thereof. As the silicone resin, a phenyl-based silicone resin or a methyl-based silicone resin can be used. From the viewpoint of durability, the methyl-based silicone resin is particularly preferable.

The methyl-based silicone resin may mean, for example, a methyl-based silicone resin in which a siloxane bond in which silicon and oxygen are alternately bonded is present as a main skeleton, there are a number of functional groups bonded to Si atoms, and for example, 60% or more, and preferably 800 or more of functional groups are methyl groups. It should be noted that the methyl-based silicone resin is not limited to the examples.

As the methyl-based silicone resin, for example, a dimethyl-based silicone resin, a methyl phenyl silicone resin, or the like can be used.

The content of the methyl-based silicone resin in the resin component only needs to be adjusted depending on desired characteristics, and is not particularly limited. For example, the content may be 100% by mass, may be 20% by mass or more and 80% by mass or less, may be 30% by mass or more and 70% by mass or less, or may be 40% by mass or more and 60% by mass or less. In the related art, in a case where metal oxide particles are contained in the methyl-based silicone resin, the metal oxide particles are agglomerated, the transparency is deteriorated, and the refractive index is not sufficiently improved. In addition, even in a case where the metal oxide particles are dispersed in the methyl-based silicone resin, it has been difficult to completely suppress the excessive agglomeration of the metal oxide particles. In contrast, the composition of the present embodiment includes the above-described metal oxide particles having a refractive index of 1.70 or higher and 2.00 or lower, which have been surface-modified with the silane compound and the silicone compound. Therefore, even in a case where the methyl-based silicone resin is included in such a large amount as the resin component, the agglomeration of the metal oxide particles is suppressed, and even in a case where the metal oxide particles are somewhat agglomerated, the refractive index of the metal oxide particles is 1.70 or higher and 2.00 or lower, whereby a decrease in transparency is suppressed. In addition, since it is possible to employ the methyl-based silicone resin, the durability of sealing members that are formed using the composition is improved.

The structure of the resin component may be a two-dimensional chain-like structure, may be a three-dimensional net-like structure, or may be a basket-like structure.

The resin component only needs to be in a cured polymer form in a case where used as a sealing member. In the composition, the resin component may be in an uncured state, that is, may be a precursor. Therefore, the resin component that is present in the composition may be, for example, a monomer, may be an oligomer, or may be a polymer.

As the resin component, an addition reaction-type resin component may be used, a condensation reaction-type resin component may be used, or a radical polymerization reaction-type resin component may be used.

The viscosity of the resin component at 25°C, which is measured in accordance with JIS Z 8803:2011, is, for example, preferably 10 mPa·s or higher and 100,000 mPa·s or lower, more preferably 100 mPa·s or higher and 10,000 mPa·s or lower, and still more preferably 1,000 mPa·s or higher and 7,000 mPa·s or lower.

In addition, a content of the resin component in the composition of the present embodiment can be the remainder of the other components, but is, for example, preferably 10% by mass or more and 98% by mass or less, and more preferably 15% by mass or more and 97% by mass or less. The content of the resin component may be 30% by mass or more, 50% by mass or more, or 60% by mass or more. The content of the resin component may be 90% by mass or less, 80% by mass or less, or 70% by mass or less.

The dispersion medium derived from the dispersion liquid of the present embodiment may be included in the composition of the present embodiment or removed from the composition. That is, the dispersion medium derived from the dispersion liquid may be completely removed. The dispersion medium may remain in the composition in an amount of approximately 1% by mass or more and 10% by mass or less, or may remain in an amount of approximately 2% by mass or more and 5% by mass or less.

In addition, the composition of the present embodiment may include the particles of a fluorescent body as long as the object of the present invention is not impaired. The particles of a fluorescent body absorb light having a specific wavelength emitted from the light emitting element and release light having a predetermined wavelength. That is, it is possible to convert the wavelength of light, and to adjust the color tone with the particles of a fluorescent body.

The particles of a fluorescent body are not particularly limited as long as the particles can be used in a light emitting device as described below, can be optionally selected, and can be appropriately selected and used such that the color of light emitted from the light emitting device becomes a desired color.

A content of the particles of a fluorescent body in the composition of the present embodiment can be appropriately adjusted such that a desired brightness can be obtained, and used.

In addition, the composition of the present embodiment may also contain an additive that is generally used such as a preservative, a polymerization initiator, a polymerization inhibitor, a curing catalyst, a light scattering agent, and the like as long as the object of the present invention is not impaired. As the light scattering agent, silica particles having an average particle diameter of 1 µm to 30 µm are preferably used.

The composition of the present embodiment can be produced by mixing the dispersion liquid of the present embodiment with a resin component. In addition, after the mixing, the dispersion medium contained in the dispersion liquid may be removed using an evaporator or the like, as necessary.

The composition of the present embodiment includes the above-described metal oxide particles having a refractive index of 1.70 or higher and 2.00 or lower, which have been surface-modified with the silane compound and the silicone compound. As a result, even in a case where the resin component includes the methyl-based silicone resin, the agglomeration of the metal oxide particles is suppressed, and thus, a decrease in transparency is suppressed even in a case of the agglomeration. Therefore, it is possible to form a sealing member that improves the brightness of light of a light emitting device, using the composition of the present embodiment.

With the composition of the present embodiment, the metal oxide particles which have been densely surface-modified with the surface-modifying material are dispersed in the resin component such that a scattering fraction at a wavelength of 450 nm of the cured product and a scattering fraction at a wavelength of 600 nm of the cured product are desired values. Therefore, in a case where the composition of the present embodiment is cured and used as a sealing member of a light emitting element, the brightness of a light emitting device can be improved.

### (Method for Producing Composition)

A method for producing the composition of the present embodiment is not particularly limited as long as the dispersion liquid obtained in the step and the resin component can be mixed.

Moreover, a step of removing the hydrophobic solvent from the obtained composition by an evaporator or the like may be provided.

In addition, materials generally included in the sealing member, such as particles of a fluorescent body, and the like, may be appropriately mixed.

### (Sealing Member)

The sealing member of the present embodiment is a cured product of the composition of the present embodiment. The sealing member of the present embodiment is generally used as a sealing member that is disposed on a light emitting element or a part thereof.

The thickness or the shape of the sealing member of the present embodiment can be appropriately adjusted depending on a desired use or characteristics, and is not particularly limited.

The sealing member of the present embodiment can be produced by curing the composition of the present embodiment as described above. A method for curing the composition can be selected depending on the characteristics of the resin component in the composition of the present embodiment. Examples of the method for curing the composition include thermal curing, electron beam curing, and the like. As described above more specifically, the sealing member of the present embodiment can be obtained by curing the resin component in the composition of the present embodiment by an addition reaction or a polymerization reaction.

A dispersed particle diameter of the surface-modified metal oxide particles in the sealing member is not particularly limited as long as a scattering fraction at a wavelength of 450 nm of the cured product and a scattering fraction at a wavelength of 600 nm of the cured product are desired values. The dispersed particle diameter of the surface-modified metal oxide particles in the sealing member may be, for example, 30 nm or higher and 1,000 nm or lower, 40 nm or higher and 900 nm or lower, 50 nm or higher and 800 nm or lower, or 60 nm or higher and 700 nm or lower. The dispersed particle diameter of the surface-modified metal oxide particles herein means a secondary particle diameter (agglomerated particle diameter) in a case where the particles are agglomerated.

The dispersed particle diameter of the surface-modified metal oxide particles in the sealing member can be measured by observing a sample, which has been obtained by cutting a cured product into a thin plate shape, with an electron microscope. However, it is difficult to observe all the surface-modified metal oxide particles in the sealing member, and therefore, it is difficult to uniquely define the particle diameter of the surface-modified metal oxide particles in the sealing member. In addition, even in a case where the particle diameters are the same, the light transmittance is different depending on a degree of agglomeration between the particles. Thus, it is difficult to accurately measure the dispersed particle diameter of the surface-modified metal oxide particles in the sealing member. Therefore, it is difficult to specify a feature of the sealing member of the present embodiment, based on the dispersed particle diameter of the surface-modified metal oxide particles.

Since the sealing member of the present embodiment is a cured product of the composition of the present embodiment, the sealing member of the present embodiment is excellent in light scattering properties and transparency. Therefore, according to the present embodiment, a sealing member that improves the brightness of light of a light emitting device can be obtained.

### (Light Emitting Device)

The light emitting device of the present embodiment is provided with the above-described sealing member and the light emitting element sealed in the sealing member.

Examples of the light emitting element include a light emitting diode (LED), an organic light emitting diode (OLED), and the like. In particular, the sealing member of the present embodiment is suitable for sealing a light emitting diode. The light emitting device of the present embodiment preferably is a white LED light emitting device using a blue LED chip.

Hereinafter, the light emitting device of the present embodiment will be described by taking an example in which the light emitting element is a light emitting diode on a chip, that is, an LED chip, and the light emitting device is an LED package.

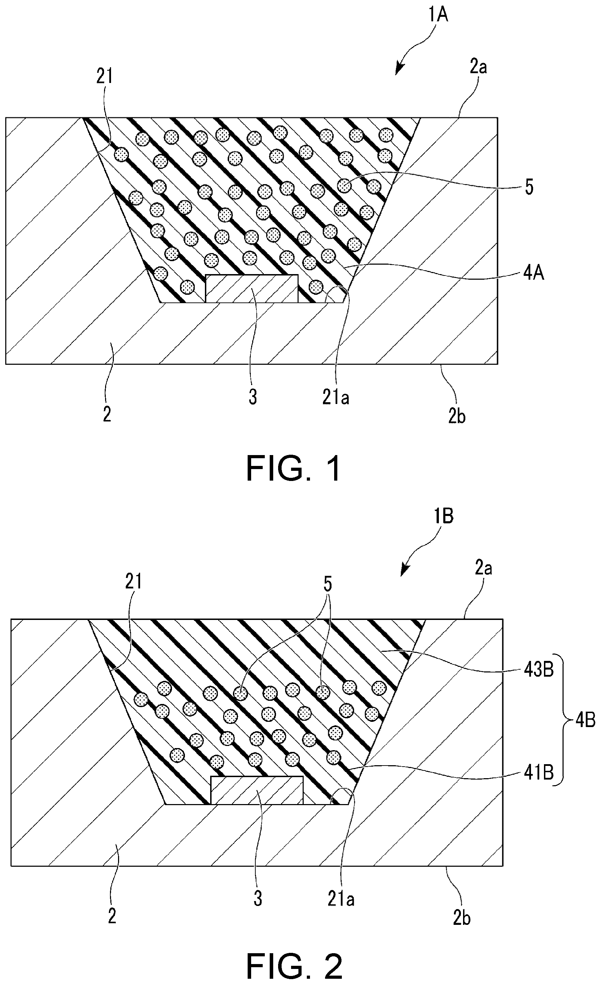

FIGS. 1 to 4 are schematic views (cross-sectional views) showing examples of the light emitting device of the present embodiment.

Furthermore, the sizes of individual members in the drawings are appropriately stressed in order to facilitate the description, and do not indicate actual dimensions and ratios between the members. Moreover, in the present specification and the drawings, configurational elements having substantially the same functional configuration will be given the same reference signs and will not be described again.

A light emitting device (LED package) 1A shown in FIG. 1 is provided with a substrate 2 having a recess portion 21, a light emitting element (LED chip) 3 that is disposed on a bottom surface of the recess portion 21 of the substrate 2, and a sealing member 4A that seals and covers the light emitting element 3 in the recess portion 21.

The sealing member 4A is configured using the above-described sealing member of the present embodiment. Therefore, in the sealing member 4A, the above-described metal oxide particles derived from the composition of the present embodiment are dispersed, and, consequently, the extraction efficiency of light in the light emitting device 1A is improved. In addition, particles 5 of a fluorescent body are dispersed in the sealing member 4A. The particles 5 of a fluorescent body convert the wavelength of at least a part of light emitted from the light emitting element 3.

A light emitting device 1B shown in FIG. 2 is different from the light emitting device 1A in terms of a fact that a sealing member 4B forms two layers. That is, the sealing member 4B has a first layer 41B that directly covers the light emitting element 3 and a second layer 43B that covers the first layer 41B. The first layer 41B and the second layer 43B are both the sealing members of the present embodiment. The particles 5 of a fluorescent body are dispersed in the first layer 41B. On the other hand, the second layer 43B does not include the particles 5 of a fluorescent body. In the light emitting device 1B, the above-described metal oxide particles derived from the composition of the present embodiment are dispersed in the first layer 41B and the second layer 43B that configure the sealing member 4B, whereby the brightness of light is improved.

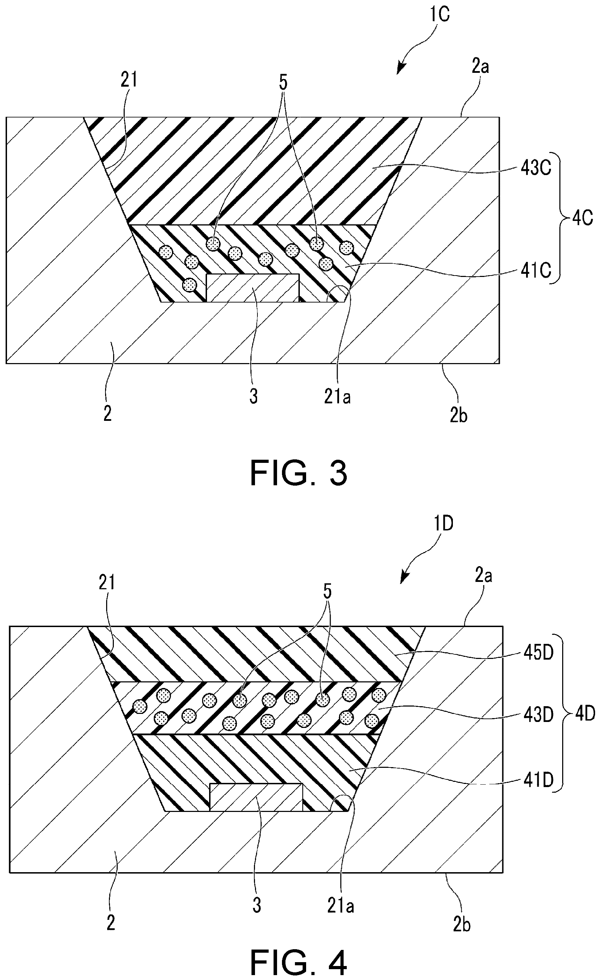

A light emitting device 1C shown in FIG. 3 is also different from the light emitting device 1A in terms of a fact that the configuration of a sealing member 4C is different from that of the sealing member 4A. The sealing member 4C has a first layer 41C that directly covers the light emitting element 3 and a second layer 43C that covers the first layer 41C. The first layer 41C is not the sealing member of the present embodiment, is a sealing member of a resin not including the above-described metal oxide particles, and is configured using a resin or the like that can be used for a sealing member. In addition, in the first layer 41C, the particles 5 of a fluorescent body are dispersed. On the other hand, the second layer 43C is the sealing member of the present embodiment. In the light emitting device 1C, the above-described metal oxide particles derived from the composition of the present embodiment are dispersed in the second layer 43C configuring the sealing member 4C, and thus, the extraction efficiency of light is improved.

In a light emitting device 1D shown in FIG. 4, a sealing member 4D has a first layer 41D that directly covers the light emitting element 3, a second layer 43D that covers the first layer 41D, and a third layer 45D that further covers the second layer 43D. The first layer 41D and the second layer 43D are not the sealing member of the present embodiment, are a sealing member of a resin not including the above-described metal oxide particles, and are configured using a resin or the like which can be used for a sealing member. In addition, the particles 5 of a fluorescent body are dispersed in the second layer 43D. On the other hand, the third layer 45D is the sealing member of the present embodiment. In the light emitting device 1D, the above-described metal oxide particles derived from the composition of the present embodiment are dispersed in the third layer 45D that configures the sealing member 4D, whereby the brightness of light is improved.

The light emitting device of the present embodiment is not limited to the aspects shown in the drawings. For example, the light emitting device of the present embodiment may not include the particles of a fluorescent body in the sealing member. In addition, the sealing member of the present embodiment can be present at any position in the light emitting device.

In the light emitting device of the present embodiment, the light emitting element is sealed with the sealing member of the present embodiment, and therefore, the brightness of light is improved.

In addition, in the light emitting device of the present embodiment, the light emitting element is sealed with the composition of the present embodiment as described above. Therefore, the present invention, in a sense, also relates to a method for producing a light emitting device having a step of sealing a light emitting element using the composition of the present embodiment. In the same sense, the production method may also have a step of obtaining the composition by mixing the dispersion liquid of the present embodiment with the resin component.

The light emitting element can be sealed by, for example, applying the composition of the present embodiment onto the light emitting element using a dispenser or the like, and then curing the composition.

### (Illumination Tool and Display Device)

The above-described light emitting device of the present embodiment can be used in, for example, an illumination tool and a display device. Therefore, the present invention relates to an illumination tool or a display device is provided with the light emitting device of the present embodiment in a sense.

Examples of the illumination tool include an ordinary illumination tool such as an indoor lamp, an outdoor lamp, and the like, and an illumination in a switch portion of an electronic device such as a mobile phone, OA equipment, and the like.

Since the illumination tool of the present embodiment is provided with the light emitting device of the present embodiment, a luminous flux thus emitted is larger, as compared with that in the related art even with a use of the same light-emitting element, making it possible to make the ambient environment brighter.

Examples of the display device include a mobile phone, a mobile information terminal, an electronic dictionary, a digital camera, a computer, a television, a peripheral device thereof, and the like.

Since the display device of the present embodiment is provided with the light emitting device of the present embodiment, a luminous flux thus emitted is larger, as compared with that in the related art even in a use of the same light emitting element, making it possible to perform displaying, for example, in a clearer and brighter manner.

### [Examples]

Hereinafter, the present invention will be described in more detail with reference to Examples and Comparative Examples. Furthermore, Examples described below are simply examples of the present invention, not limiting the present invention.

### [Example 1]

### (Manufacture of Dispersion Liquid)

### (i) Hydrolyzing Step

90.78 parts by mass of methyltriethoxysilane (product name: KBE-13, manufactured by Shin-Etsu Chemical Co., Ltd.), 9.21 parts by mass of water, and 0.01 parts by mass of hydrochloric acid (1 N) were prepared. These were added to a container and mixed to obtain a hydrolysis liquid. Next, this hydrolysis liquid was stirred at 60°C for 30 minutes and a hydrolysis treatment of methyltriethoxysilane was performed to obtain a hydrolysis liquid.

### (ii) Mixing Step (Step B)

30 parts by mass of aluminum oxide (Al₂O₃) particles (manufactured by Sumitomo Chemical Co., Ltd.) having an average primary particle diameter of 9 nm and 70 parts by mass of the hydrolysis liquid were mixed to obtain a liquid mixture. A refractive index of the aluminum oxide particles was 1.8.

### (iii) Dispersing Step (Step C)

The liquid mixture was subjected to a dispersion treatment by a beads mill for 11 hours and then the beads were removed to obtain a first dispersion liquid.

### (iv) First Adding Step (Step D)

The obtained first dispersion liquid was heated at 60°C for 2 hours. Next, toluene was added to the dispersion liquid such that the concentration of solid contents was 40% by mass, and the mixture was heated at 60°C for 2 hours.

Then, toluene was added to the dispersion liquid such that the concentration of solid contents was 30% by mass, and the mixture was heated at 60°C for 1 hour.

Next, toluene was added to the dispersion liquid such that the concentration of solid contents was 20% by mass, and the mixture was heated at 60°C for 1 hour to obtain a second dispersion liquid.

### (v) Second Adding Step (Step E)

88.1 parts by mass of the second dispersion liquid in which the concentration of solid contents had been adjusted to 20% by mass in toluene and 11.9 parts by mass of a methoxy group-containing phenyl silicone resin (product name: KR217, manufactured by Shin-Etsu Chemical Co., Ltd.) were mixed to obtain a treatment liquid, and the treatment liquid was then heated at 110°C for 1 hour to obtain a dispersion liquid (third dispersion liquid).

Next, toluene was mixed with the obtained dispersion liquid to obtain a dispersion liquid of Example 1, in which the concentration of solid contents had been adjusted to 30% by mass.

### (Manufacture of Composition)

3.8 g of the dispersion liquid of Example 1 and 15.0 g of methyl phenyl silicone (product name: KER-2500-B, manufactured by Shin-Etsu Chemical Co., Ltd.) were mixed. That is, the dispersion liquid and methyl phenyl silicone were mixed such that a ratio of the total mass of the aluminum oxide particles and the surface-modifying material to the mass of methyl phenyl silicone was 7:93.

Next, the liquid mixture was subjected to evaporation by an evaporator to remove toluene, thereby obtaining a composition of Example 1.

### (Manufacture of Cured Product)

The composition of Example 1 was filled into a 1 mm-thick SUS container coated with Teflon (registered trademark) such that a film thickness was 1 mm. Next, the composition was heated at 100°C for 2 hours and then heated at 150°C for 4 hours to obtain a cured product of Example 1. The cured product taken out from the container had a thickness of 1 mm.

### (Light Transmittance and Scattering Fraction)

The linear transmittance and the integrated transmittance of the cured product of Example 1 extracted from the container at a wavelength of 450 nm and a wavelength of 600 nm were measured using a spectrophotometer (manufactured by JASCO Corporation, model number: V-770). The integrated transmittance means a result measured using an integrating sphere. The scattering fraction was calculated from a difference between the integrated transmittance and the linear transmittance. In addition, a value determined by dividing the scattering fraction at a wavelength of 450 nm of the cured product by the scattering fraction at a wavelength of 600 nm of the cured product was obtained. The results are shown in Table 1.

### (Observation with Electron Microscope)

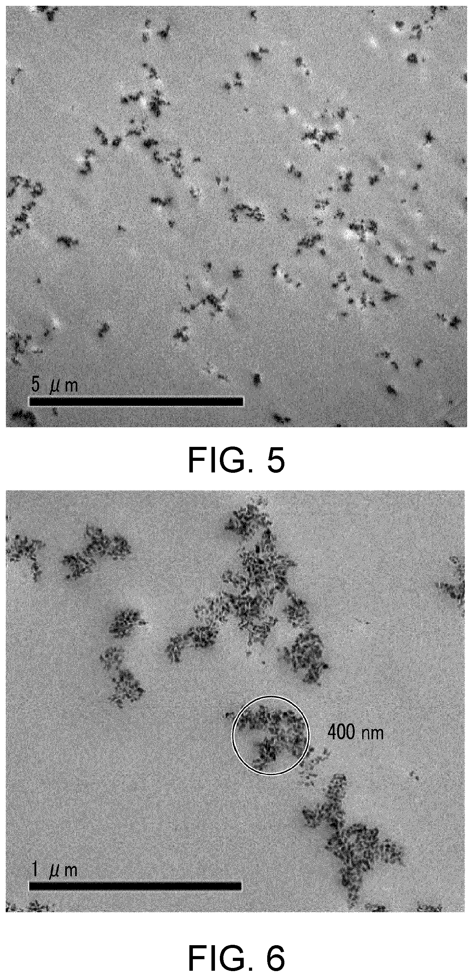

The cured product of Example 1 was sliced to prepare a sample, and the sample was observed with a field emission transmission electron microscope (product name: JEM-2100F, manufactured by JEOL Ltd.). The results are shown in FIGS. 5 and 6. From FIGS. 5 and 6, in the cured product of Example 1, the agglomerated particles having a size of about 400 nm were observed, but the agglomerated particle diameters were approximately 200 nm to 600 nm.

### (Manufacture of LED Package and Evaluation of Brightness)

A brightness of the LED package before sealing with the composition of Example 1 was measured by applying a voltage of 3 V and an electric current of 150 mA to the LED package with a total luminous flux measurement system (manufactured by Otsuka Electronics Co., Ltd.) to perform photometry. That is, the brightness A of the optical element itself was measured.

A composition obtained by mixing 1 part by mass of the composition of Example 1 and 0.38 parts by mass of particles of a fluorescent body (yttrium aluminum garnet: YAG) were mixed (a total amount of the surface modification aluminum oxide particles and the resin:the particles of a fluorescent body = 100:38) was filled into a lead frame with a thickness of 300 um. After that, the composition was held at room temperature for 3 hours. Next, the composition was slowly heated and cured to form a sealing member of Example 1, thereby manufacturing a white LED package of Example 1.

A brightness B of the obtained white LED package of Example 1 was measured by applying a voltage of 3 V and an electric current of 150 mA to the LED package with a total luminous flux measurement system (manufactured by Otsuka Electronics Co., Ltd.) to perform photometry.

An improvement rate of the brightness B (lm) of the white LED package of Example 1 with respect to the brightness A (lm) of the optical element itself was calculated. The result is shown in Table 1.

### [Example 2]

### (i) Hydrolyzing Step

90.78 parts by mass of methyltriethoxysilane (product name: KBE-13, manufactured by Shin-Etsu Chemical Co., Ltd.), 9.21 parts by mass of water, and 0.01 parts by mass of hydrochloric acid (1 N) were prepared. These were added to a container and mixed to obtain a hydrolysis liquid. Next, this hydrolysis liquid was stirred at 60°C for 30 minutes and a hydrolysis treatment of methyltriethoxysilane was performed to obtain a hydrolysis liquid.

47.92 parts by mass of propyltriethoxysilane (product name: KBE-3033, manufactured by Shin-Etsu Chemical Co., Ltd.), 4.15 parts by mass of water, 0.02 parts by mass of hydrochloric acid (1 N), and 47.92 parts by mass of methanol were prepared. These were added to a container and mixed to obtain a hydrolysis liquid. The hydrolysis liquid was stirred at 60°C for 1 hour and subjected to a hydrolysis treatment of propyltriethoxysilane to obtain a hydrolysis liquid.

### (ii) Mixing Step (Step B)

30 g of aluminum oxide (Al₂O₃) particles (manufactured by Sumitomo Chemical Co., Ltd.) having an average primary particle diameter of 9 nm, 77.1 g of a hydrolysis liquid of methyltriethoxysilane, and 32.6 g of a hydrolysis liquid of propyltriethoxysilane were mixed to obtain a liquid mixture. That is, these were added such that the aluminum oxide particles, the methyltriethoxysilane, and the propyltriethoxysilane were at a mass ratio of 30:49:21. A refractive index of the aluminum oxide particles was 1.8.

A dispersion liquid of Example 2, in which the concentration of solid contents was adjusted to 30% by mass, was obtained by performing the step C, the step D, and the step E in the same manner as in Example 1, except that the mixture obtained in the step B of Example 2 was used instead of the mixture obtained in the step B of Example 1 in the dispersing step (step C) of Example 1.

A composition of Example 2 and a cured product of Example 2 were obtained in the same manner as in Example 1, except that the dispersion liquid of Example 2 was used instead of the dispersion liquid of Example 1.

The light transmittance and the like of the cured product of Example 2 were measured in the same manner as in Example 1. The result is shown in Table 1.

A sample obtained by slicing the cured product of Example 2 in the same manner as in Example 1 was observed with an electron microscope. As a result, in the cured product of Example 2, the agglomerated particles having a size of approximately 400 nm were observed, but the agglomerated particle diameters were about 200 nm to 600 nm. In the cured product of Example 2, many of the agglomerated particle diameters were smaller than those of the cured product of Example 1.

An LED package of Example 2 was manufactured in the same manner as in Example 1, except that the composition of Example 2 was used instead of the composition of Example 1.

In the same manner as in Example 1, the brightness of the LED package before sealing with the composition of Example 2 and the brightness of the LED package of Example 2 were each measured, and an improvement rate in brightness of the LED package was calculated. The result is shown in Table 1.

### [Comparative Example 1]

A dispersion liquid of Comparative Example 1, in which the concentration of solid contents was adjusted to 30% by mass, was obtained in the same manner as in Example 1, except that zirconium oxide particles having an average primary particle diameter of 12 nm were used instead of the aluminum oxide particles having an average primary particle diameter of 9 nm, and the dispersion time in the beads mill was changed from 11 hours to 6 hours in Example 1. A refractive index of the aluminum oxide particles was 1.8.

A composition of Comparative Example 1 was obtained in the same manner as in Example 1, except that the dispersion liquid of Comparative Example 1 was used instead of the dispersion liquid of Example 1 in the manufacture of the composition of Example 1. Next, toluene was removed in the same manner as in Example 1 to obtain the composition of Comparative Example 1.

A cured product of Comparative Example 1 was obtained in the same manner as in Example 1, except that the composition of Comparative Example 1 was used instead of the composition of Example 1, and the light transmittance and the like were measured in the same manner as in Example 1. The result is shown in Table 1.

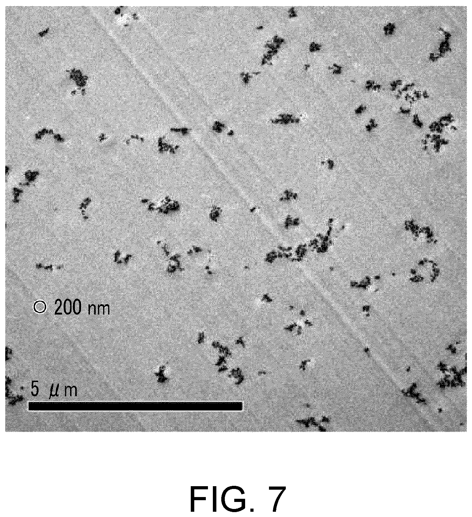

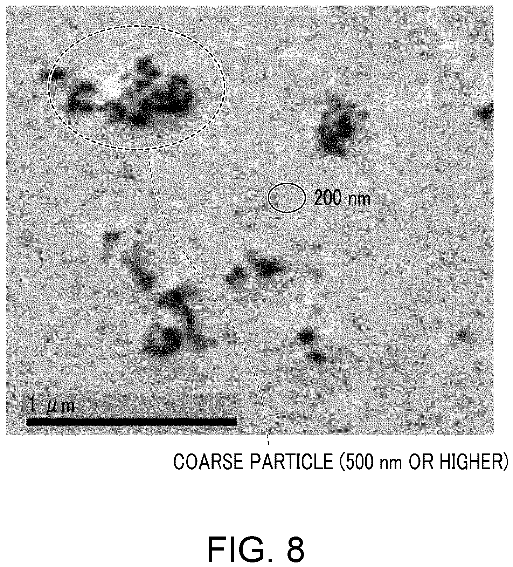

A sample obtained by slicing the cured product of Comparative Example 1 in the same manner as in Example 1 was observed with an electron microscope. The results are shown in FIGS. 7 and 8. From FIGS. 7 and 8, it was confirmed that in the cured product of Comparative Example 1, many agglomerated particles of 500 nm or higher were formed.

A LED package of Comparative Example 1 was manufactured in the same manner as in Example 1, except that the composition of Example 1 was used instead of the composition of Comparative Example 1.

In the same manner as in Example 1, the brightness of the LED package before sealing with the composition of Comparative Example 1 and the brightness of the LED package of Comparative Example 1 were each measured, and an improvement rate in brightness of the LED package was calculated. The result is shown in Table 1. In the LED package of Comparative Example 1, the brightness was reduced, as compared with the LED package of Comparative Example 1 before sealing with the sealing member.

### [Comparative Example 2]

A composition of Comparative Example 2 was obtained in the same manner as in Example 1, except that the dispersion treatment with a beads mill in the dispersing step was changed from 11 hours to 22 hours in Example 1.

A cured product of Comparative Example 2 was obtained in the same manner as in Example 1, except that the composition of Comparative Example 2 was used instead of the composition of Example 1, and the light transmittance was observed in the same manner as in Example 1. The result is shown in Table 1.

A sample obtained by slicing the cured product of Comparative Example 2 in the same manner as in Example 1 was observed with an electron microscope. As a result, the agglomerated particle diameters were approximately 200 nm to 600 nm in the same manner as in Example 1.

A LED package of Comparative Example 2 was manufactured in the same manner as in Example 1, except that the composition of Example 1 was used instead of the composition of Comparative Example 2.

In the same manner as in Example 1, the brightness of the LED package before sealing with the composition of Comparative Example 2 and the brightness of the LED package of Comparative Example 2 were each measured, and an improvement rate in brightness of the LED package was calculated. The result is shown in Table 1. In the LED package of Comparative Example 2, the brightness was reduced, as compared with the LED package of Comparative Example 2 before sealing with the sealing member.

By comparing Examples 1 and 2 with Comparative Examples 1 and 2, it was confirmed that, in a case where a cured product was obtained under predetermined conditions using surface-modified metal oxide particles in which metal oxide particles having a refractive index of 1.70 or higher and 2.00 or lower had been densely treated with a methyl group-containing silane compound, the brightness of a LED package formed using the dispersion liquid, in which a scattering fraction at a wavelength of 450 nm was 17% or more and 38% or less, and a value obtained by dividing the scattering fraction at a wavelength of 450 nm by a scattering fraction at a wavelength of 600 nm was 1.25 or more, had an improved brightness of an LED package.

The cured products of Example 1 and Comparative Example 2 could not be distinguished by microscopic observation, but the scattering fraction at a wavelength of 450 nm, or a balance between the scattering at a wavelength of 450 nm and the scattering at a wavelength of 600 nm was poor, and therefore, the brightness of the LED package was not improved.

Based on these results, it was suggested that it is possible to optimize the conditions of the cured product for improving the brightness of the LED package by adjusting the dispersion conditions, focusing on the scattering fraction at a wavelength of 450 nm and the scattering fraction at a wavelength of 600 nm.

**[Table 1]**

| | | Example 1 | Example 2 | Comparative Example 1 | Comparative Example 2 |
|---|---|---|---|---|---|
| Dispersion liquid | Type of particles | Al₂O₃ | Al₂O₃ | ZrO₂ | Al₂O₃ |
| | Methyltriethoxysilane:propyltriethoxysilane (mass ratio) | 100:0 | 70:30 | 100:0 | 100:0 |
| | Dispersion time (h) | 11 | 11 | 6 | 22 |
| Cured product | Linear transmittance (%) at 450 nm | 61.4 | 60.7 | 2.0 | 69.2 |
| | Integrated transmittance (%) at 450 nm | 88.0 | 84.5 | 65.9 | 89.5 |
| | Scattering fraction (%) at 450 nm | 26.6 | 23.8 | 63.9 | 20.3 |
| | Linear transmittance (%) at 600 nm | 68.7 | 70.4 | 13.3 | 67.9 |
| | Integrated transmittance (%) at 600 nm | 89.3 | 86.8 | 71.8 | 90.1 |
| | Scattering fraction (%) at 600 nm | 20.5 | 16.4 | 58.5 | 22.2 |
| | Scattering at 450 nm/Scattering at 600 nm | 1.30 | 1.45 | 1.09 | 0.91 |
| LED package | Improvement rate (%) of brightness | 0.10% | 0.60% | -3.25% | -0.98% |

Hitherto, the preferred embodiments of the present invention have been described in detail with reference to the accompanying drawings, but the present invention is not limited to such examples. It is evident that a person skilled in the art of the present invention is able to conceive a variety of modification examples or correction examples within the scope of the technical concept described in the claims, and it is needless to say that such examples are understood to be in the technical scope of the present invention.

### Industrial Applicability

According to the present invention, it is possible to provide a dispersion liquid capable of improving the brightness of a light emitting device even in a case where a methyl-based silicone resin is used as a sealing material.

### Reference Signs List

1A, 1B, 1C, 1D Light emitting device
2 Substrate
2a Upper part of substrate
2b Lower part of substrate
21 Recess portion
21a Bottom of recess portion
3 Light emitting element
4A, 4B, 4C, 4D Sealing member
41B, 41C, 41D First layer
43B, 43C, 43D Second layer
45D Third layer
5 Particle of fluorescent body

## Claims

1. A dispersion liquid comprising:
metal oxide particles surface-modified with a surface-modifying material; and
a hydrophobic solvent,
wherein the metal oxide particles have a refractive index of 1.70 or higher and 2.00 or lower,
the surface-modifying material includes a silane compound and a silicone compound,
the silane compound includes a methyl group-containing silane compound,
in a case where the dispersion liquid and methyl phenyl silicone are mixed such that a ratio of a total mass of the metal oxide particles and the surface-modifying material to a mass of methyl phenyl silicone is 7:93, thereby obtaining a cured product having a thickness of 1 mm,
a scattering fraction at a wavelength of 450 nm of the cured product is 170 or more and 38% or less, and
a value obtained by dividing the scattering fraction at the wavelength of 450 nm of the cured product by a scattering fraction at a wavelength of 600 nm of the cured product is 1.25 or higher.

2. The dispersion liquid according to claim 1,
wherein the silane compound further includes a silane compound containing a hydrocarbon group having 2 to 5 carbon atoms.

3. A composition which is a mixture of the dispersion liquid according to claim 1 or 2 and a resin component.

4. A sealing member which is a cured product of the composition according to claim 3.

5. A light emitting device comprising:
the sealing member according to claim 4; and
a light emitting element sealed by the sealing member.

6. An illumination tool comprising:
the light emitting device according to claim 5.

7. A display device comprising:
the light emitting device according to claim 5.

8. A method for producing the dispersion liquid according to claim 2, the method comprising:
a step B of mixing a silane compound and metal oxide particles to obtain a liquid mixture;
a step C of dispersing the metal oxide particles in the liquid mixture to obtain a first dispersion liquid in which the metal oxide particles are dispersed;
a step D of adding a hydrophobic solvent to the first dispersion liquid to obtain a second dispersion liquid; and
a step E of adding a silicone compound to the second dispersion liquid to obtain a third dispersion liquid,
wherein the metal oxide particles have a refractive index of 1.70 or higher and 2.00 or lower,
the silane compound includes a methyl group-containing silane compound and a silane compound containing a hydrocarbon group having 2 to 5 carbon atoms,
in the step B, a content of the metal oxide particles in the liquid mixture is 10% by mass or more and 49% by mass or less, and a total content of the silane compound and the metal oxide particles in the liquid mixture is 650 by mass or more and 98% by mass or less, and
the step D is any of:
a step d1 of heating the first dispersion liquid and then adding the hydrophobic solvent to the first dispersion liquid at a rate at which the metal oxide particles are not agglomerated,
a step d2 of adding the hydrophobic solvent to the first dispersion liquid at a rate at which the metal oxide particles are not agglomerated, while heating the first dispersion liquid, or
a step d3 of adding the hydrophobic solvent to the first dispersion liquid at a rate at which the metal oxide particles are not agglomerated, and then heating the first dispersion liquid.
